(19) Europäisches Patentamt
European Patent Office
Office européen des brevets

(11) EP 3 232 747 A1

(12) EUROPEAN PATENT APPLICATION

(43) Date of publication:
**18.10.2017 Bulletin 2017/42**

(51) Int Cl.:
***H05K 3/02*** (2006.01) ***H05K 3/38*** (2006.01)

(21) Application number: **17166671.2**

(22) Date of filing: **13.04.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **15.04.2016 JP 2016082425**

(71) Applicant: **JX Nippon Mining & Metals Corp.**
**Chiyoda-ku**
**Tokyo 1008164 (JP)**

(72) Inventor: **FUKUCHI, Ryo**
**Hitachi-shi, Ibaraki 317-0056 (JP)**

(74) Representative: **Yeadon IP Limited**
**Leeds Innovation Centre**
**103 Clarendon Road**
**Leeds LS2 9DF (GB)**

(54) **COPPER FOIL, COPPER FOIL FOR HIGH-FREQUENCY CIRCUIT, CARRIER-ATTACHED COPPER FOIL, CARRIER-ATTACHED COPPER FOIL FOR HIGH-FREQUENCY CIRCUIT, LAMINATE, METHOD OF MANUFACTURING PRINTED WIRING BOARD, AND METHOD OF MANUFACTURING ELECTRONIC DEVICE**

(57) To provide a copper foil that the transmission loss is favorably controlled even when the copper foil is used in a high-frequency circuit board and that adhesion to a resin is favorable.

A copper foil including a roughened layer, and the roughened layer includes a primary particle layer, a surface roughness Ra of a surface on the side of the primary particle layer is 0.12 μm or less, and the average particle size of primary particles of the primary particle layer is 0.10 to 0.25 μm.

FIG.1

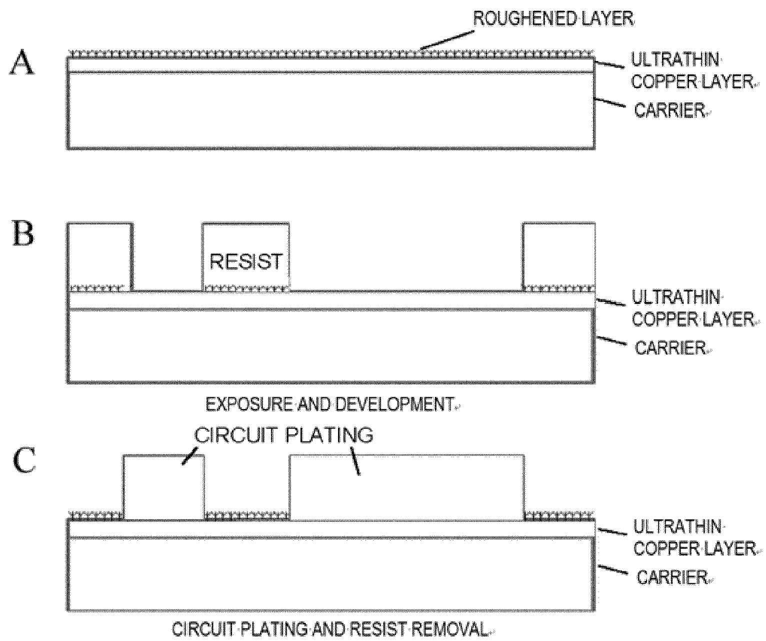


EP 3 232 747 A1

## Description

[Technical Field]

The present invention relates to a copper foil, a copper foil for a high-frequency circuit, a carrier-attached copper foil, a carrier-attached copper foil for a high-frequency circuit, a laminate, a method of manufacturing a printed wiring board, and a method of manufacturing electronic devices.

[Background Art]

Printed wiring boards have made significant progress for the past half century and are used in almost all electronic devices nowadays. In recent years, with the increasing needs for downsizing and higher performance of electronic devices, higher density packaging of mounted components and signal transmission at higher frequencies have been accelerated, and as a result, printed wiring boards are now required to better handle signal transmission at higher frequencies.
A substrate for higher frequencies is required to keep transmission loss as small as possible to ensure signal quality. The transmission loss is mainly divided into two losses: dielectric loss that is caused by a resin (substrate side) and conductor loss that is caused by a conductor (copper foil side) . The dielectric loss can be reduced as the dielectric constant and the dielectric tangent (DF) become smaller. In high-frequency signals, the main causes of the conductor loss is that a cross-sectional area that the electric current flows is reduced and the resistance is increased due to the skin effect that is the tendency such that the electric current flows nearer to the surface of a conductor as the frequency becomes higher.
As a technology to reduce the transmission loss in a copper foil for high-frequency circuits, Patent Literature 1, for example, discloses a metal foil for a high frequency circuit in which one or both sides of the metal foil is/are coated with silver or a silver alloy, and a coating layer of a metal other than silver or a silver alloy is provided on the silver or the silver alloy in a manner that the thickness of the coating layer is thinner than that of the silver or the silver alloy. According to Patent Literature 1, it is possible to provide a metal foil with reduced loss due to the skin effect even in super high frequency bands that are used in satellite communication.
Patent Literature 2 discloses a roughened rolled copper foil for high frequency circuits that is a material for a printed circuit board and is characterized in that the integrated intensity (I(200)) of the (200) plane obtained by X-ray diffraction on a rolled surface of a rolled copper foil after recrystallization annealing and the integrated intensity (I0 (200)) of the (200) plane obtained by X-ray diffraction of fine powder copper satisfy a relation of I (200) /I0 (200) >40, and after the rolled surface undergoes roughening treatment by electroplating, the roughened surface has the arithmetic average roughness (hereinafter referred to as Ra) of 0.02 μm-0.2 μm and the ten-point average roughness (hereinafter referred to as Rz) of 0.1 μm-1.5 μm. According to Patent Literature 2, it is possible to provide a printed circuit board that can be used in a high frequency band over 1 GHz.
Moreover, Patent Literature 3 discloses an electrolytic copper foil that is characterized in that a part of a surface of the copper foil is a rugged surface of 2 μm-4 μm in surface roughness and is composed of bunchy projections. According to Patent Literature 3, it is possible to provide an electrolytic copper foil that has good high-frequency transmission characteristics.

[Citation List]

[Patent Literature]

Patent Literature 1: Japanese Patent No. 4161304
Patent Literature 2: Japanese Patent No. 4704025
Patent Literature 3: Japanese Patent Laid-Open Application No. 2004-244656

[Summary of Invention]

[Technical Problem]

The conductor loss caused by a conductor (copper foil side) results from increase in resistance due to the skin effect as described above, but this resistance is not only the resistance of the copper foil itself but also is affected by the resistance caused by the roughening treatment applied to ensure adhesiveness between the surface of the copper

foil and a resin substrate. More specifically, the surface roughness of the copper foil is the main cause of the conductor loss, and the transmission loss would be decreased as the roughness becomes smaller.

Accordingly, it is an object of the present invention to provide such a copper foil that the transmission loss is favorably controlled even when the copper foil is used in a high-frequency circuit board and that adhesion to a resin is favorable.

The inventors of the present invention have found out that forming a prescribed roughening particle layer on a surface of the copper foil and controlling the surface roughness Ra and the average particle size of the roughening particles on the surface of the roughening particle layer are very effective in controlling the transmission loss when the copper foil is used in a high-frequency circuit board and in obtaining good adhesion of the copper foil to a resin.

The present invention was made on the basis of the above findings, and one aspect of the present invention is a copper foil having a roughened layer, the roughened layer includes a primary particle layer, the surface roughness Ra of a surface on the side of the primary particle layer is 0.12 μm or less, and the average particle size of the primary particles of the primary particle layer is 0.10 to 0.25 μm.

In one of the embodiments of the copper foil according to the present invention, the roughened layer has a secondary particle layer on or over the primary particle layer, and the average particle size of the secondary particles of the secondary particle layer is 0.35 μm or less.

In another embodiment of the copper foil according to the present invention, the average particle size of the primary particles of the primary particle layer is less than 0.25 μm.

In another embodiment of the copper foil according to the present invention, the average particle size of the primary particles of the primary particle layer is 0.244 μm or less.

In another embodiment of the copper foil according to the present invention, a circuit is formed by attaching a resin with the dielectric constant being 2.4, the dielectric tangent being 0.001, and the thickness being 50 μm to a surface on the side of the roughened layer of the copper foil, by making the thickness of the copper foil be 18 μm, and by etching the copper foil so that the characteristic impedance of the circuit is 50 Ω, and when the transmission loss of the circuit is measured at a frequency of 60 GHz, the transmission loss is 8.4 dB/10cm or less.

In another embodiment of the copper foil according to the present invention, a circuit is formed by attaching a resin with the dielectric constant being 2.9, the dielectric tangent being 0.002, and the thickness being 50 μm to a surface on the side of the roughened layer of the copper foil, by making the thickness of the copper foil be 18 μm, and by etching the copper foil so that the characteristic impedance of the circuit is 50 Ω, and when the transmission loss of the circuit is measured at a frequency of 60 GHz, the transmission loss is 8.4 db/10 cm or less.

In another embodiment of the copper foil according to the present invention, a circuit is formed by attaching a resin with the dielectric constant being 3.2, the dielectric tangent being 0.002, and the thickness being 50 μm to a surface on the side of the roughened layer of the copper foil, by making the thickness of the copper foil be 18 μm, and by etching the copper foil so that the characteristic impedance of the circuit is 50 Ω, and when the transmission loss of the circuit is measured at a frequency of 60 GHz, the transmission loss is 8.4 dB/10cm or less.

In another embodiment of the copper foil according to the present invention, the total content of Co and Ni in the roughened layer is 2000 $\mu g/dm^2$ or less.

In another embodiment of the copper foil according to the present invention, the total content of Co in the roughened layer is 1000 $\mu g/dm^2$ or less.

In another embodiment of the copper foil according to the present invention, the total content of Ni in the roughened layer is 1000 $\mu g/dm^2$ or less.

In another embodiment of the copper foil according to the present invention, the surface roughness Rz of a surface on the side of the primary particle layer is 1.6 μm or less.

In another embodiment of the copper foil according to the present invention, the copper foil has one or more layer selected from a group of a heat-resistant layer, a rustproofing layer, a chromate treated layer, and a silane coupling-treated layer on the surface of the roughened layer.

In another embodiment of the copper foil according to the present invention, the copper foil has a resin layer on the surface on the side of the roughened layer.

In another embodiment of the copper foil according to the present invention, the resin layer is an adhesive resin and/or a resin in a semi-cured state.

In another embodiment of the copper foil according to the present invention, the copper foil is a copper foil for a high-frequency circuit.

Another aspect of the present invention is a carrier-attached copper foil having an intermediate layer and an ultra-thin copper layer in this order on one or both of surfaces of a carrier, and the ultra-thin copper layer is the copper foil according to the present invention.

In another embodiment of the carrier-attached copper foil according to the present invention, the carrier-attached copper foil is a copper foil for a high-frequency circuit.

Another aspect of the present invention is a laminate having the copper foil according to the present invention,

or the carrier-attached copper foil according to the present invention.

Another aspect of the present invention is a laminate having a resin and the carrier-attached copper foil according to the present invention, and a portion or entirety of an end face of the carrier-attached copper foil is covered with the resin.

Another aspect of the present invention is a laminate in which a side of the carrier or a side of the ultra-thin copper layer of one carrier-attached copper foil according to the present invention is attached to a side of the carrier or a side of the ultra-thin copper layer of another carrier-attached copper foil according to the present invention.

Another aspect of the present invention is a method of manufacturing a printed wiring board by using the copper foil according to the present invention or the carrier-attached copper foil according to the present invention.

Another aspect of the present invention is a method of manufacturing a printed wiring board, including a step of preparing the copper foil according to the present invention or the carrier-attached copper foil according to the present invention and an insulating substrate, a step of forming a copper-clad laminate by laminating the copper foil and the insulating substrate or forming a copper-clad laminate by laminating the carrier-attached copper foil and the insulating substrate and detaching a carrier from the carrier-attached copper foil, and a step of forming a circuit by any one of a semi-additive method, a subtractive method, a partly additive method, and a modified semi-additive method.

Another aspect of the present invention is a method of manufacturing a printed wiring board, including a step of forming a circuit on a surface on a side of the roughened layer of the copper foil according to the present invention or forming a circuit on a surface on a side of the ultra-thin copper layer or a surface on a side of the carrier of the carrier-attached copper foil according to the present invention, a step of forming a resin layer on the surface on the side of the roughened layer of the copper foil or on the surface of the side of the carrier of the carrier-attached copper foil so that the circuit is buried, a step of forming a circuit on the resin layer, and after the step of forming the circuit on the resin layer, a step of exposing the circuit buried in the resin layer by removing the copper foil or by removing the ultra-thin copper layer or the carrier after detaching the ultra-thin copper layer or the carrier.

Another aspect of the present invention is a method of manufacturing a printed wiring board, including a step of laminating the carrier-attached copper foil according to the present invention and a resin substrate, a step of providing at least once two layers including a resin layer and a circuit on a surface opposite to a side of the carrier-attached copper foil on which the carrier-attached copper foil is attached to the resin substrate, and after the step of forming the two layers including the resin layer and the circuit, a step of detaching the carrier or the ultra-thin copper layer from the carrier-attached copper foil.

Another aspect of the present invention is a method of manufacturing a printed wiring board, including a step of providing at least once two layers including a resin layer and a circuit on one or both of surfaces of the laminate according to the present invention, and after the step of forming the two layers the resin layer and the circuit, a step of detaching the carrier or the ultra-thin copper layer from the carrier-attached copper foil of the laminate.

Another aspect of the present invention is a method of manufacturing an electronic device by using a printed wiring board manufactured by the method according to the present invention.

[Advantageous Effect of Invention]

According to the present invention, it is possible to provide a copper foil such that the transmission loss is favorably controlled even when the copper foil is used in a high-frequency circuit board and that adhesion to a resin is favorable.

[Brief Description of Drawings]

[Figure 1] Figure 1A-C is a schematic cross-sectional view of a wiring board at the steps up to the circuit plating/removal of the resist according to a specific example of the method of manufacturing a printed wiring board using the carrier-attached copper foil of the present invention.

[Figure 2] Figure 2D-F is a schematic cross-sectional view of the wiring board at the steps from the lamination of the resin and the second layer of the carrier-attached copper foil to laser drilling according to a specific example of the method for manufacturing a printed wiring board using the carrier-attached copper foil of the present invention.

[Figure 3] Figure 3G-I is a schematic cross-sectional view of the wiring board at the steps from via fill formation to the removal of the carrier of the first layer according to a specific example of the method for manufacturing a printed wiring board using the carrier-attached copper foil of the present invention.

[Figure 4] Figure 4J-K is a schematic cross-sectional view of the wiring board at the steps from flash etching to formation of a bump and a copper pillar according to a specific example of the method for manufacturing a printed wiring board using the carrier-attached copper foil of the present invention.

[Description of Embodiments]

The form of the copper foil that can be used for the present invention is not particularly limited, but typically the copper foil used in the present invention may be an electrolytic copper foil or a rolled copper foil. In general, an electrolytic copper foil is manufactured by copper sulfate plating bath and electrolytic deposition of copper on a titanium or stainless drum, and a rolled copper foil is manufactured by repeating plastic working and heat treatment using a mill roll. A rolled copper foil is more frequently used in the use that requires flexibility.

Materials of the copper foil may include a highly pure copper such as a tough pitch copper and an oxygen-free copper that are usually used for a conductor pattern of a printed wiring board, and in addition, a copper containing Sn, a copper containing Ag, and a copper alloy such as a Cr, Zr or Mg-added copper alloy and a Ni and Si-added Corson copper alloy can also be used. Note that when the term "copper foil" is used alone in this specification, the term includes a copper alloy foil. A thickness of the copper foil does not need to be limited specifically, but the thickness is typically 1 to 1000μm, 1 to 500μm, 1 to 300μm, 3 to 100μm, 5 to 70μm, 6 to 35μm, or 9 to 18μm.

It should be noted that in another aspect, the present invention is a carrier-attached copper foil that has a carrier, an intermediate layer, and an ultra-thin copper layer in this order, and this ultra-thin copper layer is the copper foil of the present invention. When the carrier-attached copper foil is used in the present invention, a surface treatment layer such as a roughened layer that is described later is provided on the surface of the ultra-thin copper layer. Note that other embodiments of the carrier-attached copper foil is also described later. Also note that the copper foil or the carrier-attached copper foil according to the present invention is suitably used in high-frequency circuit applications. Here, a high-frequency circuit is a circuit from which a signal frequency transmitted is 1 GHz or higher.

Normally, a roughening treatment that makes "knob-like" electrodeposits (dendritic electrodeposits) on a degreased surface of a copper foil is performed on a surface adhered to a resin substrate, or a roughened surface of the copper foil, for the purpose of improving peel strength of a laminated copper foil. An electrolytic copper foil usually has a surface asperity at the time of manufacture, but projections of the surface asperity on the electrolytic copper foil is enhanced by the roughening treatment to have a greater surface asperity. Regular copper plating may be performed as the pretreatment of the roughening, or such copper plating may be performed for the finishing after the roughening to prevent the electrodeposits from falling off.

In the present invention, "roughening treatment" includes any treatments known in the art that are related to copper foil roughening as appropriate, in addition to the above-described pretreatment and finishing.

In the copper foil according to the present invention, the roughened layer has a primary particle layer, and the average particle size of primary particles of the primary particle layer is 0.10-0.25 μm. When the average particle size of the primary particles of the primary particle layer is less than 0.10 μm, adhesion strength to a resin such as a substrate for high-frequency circuits may be decreased. When the average particle size of the primary particles of the primary particle layer exceeds 0.25 μm, the conductor loss may be increased and the high frequency characteristic may be degraded. The average particle size of the primary particles of the primary particle layer is preferably 0.10-0.20 μm, or is more preferably 0.10-0.15 μm. In addition, the average particle size of the primary particles of the primary particle layer is preferably less than 0.25 μm, is preferably 0.244 μm or less, is preferably 0.24 μm or less, is more preferably 0.234 μm or less, is more preferably 0.23 μm or less, is more preferably 0.22 μm or less, is more preferably 0.21 μm or less, is more preferably 0.204 μm or less, is more preferably 0.20 μm or less, is more preferably 0.19 μm or less, is more preferably 0.18 μm or less, is more preferably 0.17 μm or less, is more preferably 0.16 μm or less, is more preferably 0.15 μm or less, is more preferably 0.145 μm or less, is more preferably 0.14 μm or less, is more preferably 0.13 μm or less, and is more preferably 0.125 μm or less.

Of the copper foil according to the present invention, the surface roughness Ra (arithmetic mean roughness) of the surface on the primary particle layer side is 0.12 μm or less. When the surface roughness Ra of the surface on the primary particle layer side exceeds 0.12 μm, the conductor loss at high frequencies may be increased due to skin effect. The surface roughness Ra of the surface on the primary particle layer side is preferably 0.12 μm or less, is more preferably 0.11 μm or less, is more preferably 0.10 μm or less, is more preferably 0.09 μm or less, is furthermore preferably 0.08 μm or less, and is furthermore preferably 0.07 μm or less. The surface roughness Ra of the surface on the primary particle layer side of the copper foil according to the present invention is typically 0.04-0.12 μm, 0.06-0.12 μm, or 0.08-0.12 μm. The lower limit of the surface roughness Ra of the surface on the primary particle layer side of the copper foil according to the present invention does not need to be limited specifically, but the lower limit is typically 0.001 μm or more as an example, 0.005 μm or more as an example, 0.007 μm or more as an example, 0.01 μm or more as an example, 0.02 μm or more, 0.03 μm or more, 0.04 μm or more, or 0.05 μm or more.

It should be noted that in the present invention, when the copper foil has other layer(s) such as a secondary particle layer and/or a heat-resistant layer and/or a rustproofing layer and/or a chromate treated layer and/or a silane coupling-treated layer and/or a surface treated layer on the primary particle layer, "a surface on the primary particle layer side" of the copper foil refers to a surface of the outermost layer from among the other layer(s). In other words, when the copper foil has the above-described other layer(s) on the primary particle layer, "a surface on the primary particle

layer side" of the copper foil refers to the outermost surface of the copper foil after the other layer(s) is/are provided. Alternatively, when the copper foil does not have the above-described other layer(s), "a surface on the primary particle layer side" of the copper foil refers to the outermost surface of the copper foil after the primary particle layer is provided.

Moreover, in the present invention, when the copper foil has other layer(s) such as a heat-resistant layer and/or a rustproofing layer and/or a chromate treated layer and/or a silane coupling-treated layer and/or a surface treated layer on the roughened layer, "a surface on the roughened layer side" of the copper foil refers to a surface of the outermost layer from among the other layer(s). In other words, when the copper foil has the above-described other layer(s) on the roughened layer, "a surface on the roughened layer side" of the copper foil refers to the outermost surface of the copper foil after the other layer(s) is/are provided. Alternatively, when the copper foil does not have the above-described other layer(s), "a surface on the roughened layer side" of the copper foil refers to the outermost surface of the copper foil after the roughened layer is provided.

In the copper foil according to the present invention, the surface roughness Rz (ten point average roughness) of the surface on the primary particle layer side is preferably 1.60 μm or less. This is because the conductor loss may be further reduced by keeping the surface roughness Rz (ten point average roughness) of the surface on the primary particle layer side of the above-described copper foil 1.60 μm or less. The surface roughness Rz of the surface on the primary particle layer side of the copper foil is preferably 1.55 μm or less, is preferably 1.50 μm or less, is preferably 1.45 μm or less, is preferably 1.40 μm or less, is preferably 1.35 μm or less, is preferably 1.30 μm or less, is preferably 1.25 μm or less, is preferably 1.20 μm or less, is preferably 1.15 μm or less, is preferably 1.10 μm or less, is preferably 1.05 μm or less, is preferably 1.00 μm or less, is preferably 0.95 μm or less, is preferably 0.90 μm or less, is preferably 0.85 μm or less, is preferably 0.80 μm or less, is preferably 0.75 μm or less, and is more preferably 0.70 μm or less. Furthermore, the lower limit of the surface roughness Rz of the surface on the primary particle layer side of the copper foil according to the present invention does not need to be limited specifically, but the lower limit is typically 0.001 μm or more as an example, 0.005 μm or more as an example, 0.007 μm or more as an example, 0.01 μm or more as an example, 0.02 μm or more, 0.03 μm or more, 0.04 μm or more, or 0.05 μm or more.

The roughened layer preferably has a secondary particle layer on the primary particle layer. The secondary particle layer has secondary particles. When the roughened layer has a secondary particle layer, the average particle size of secondary particles of the secondary particle layer is preferably 0.35 μm or less. According to this structure, an advantage is obtained such that the increase in the conductor loss as a result of increased roughness can be controlled. The average particle size of secondary particles of the secondary particle layer is more preferably 0.30 μm or less, is further more preferably 0.20 μm or less, is further more preferably 0.15 μm or less, and is typically 0.1-0.35 μm, 0.15-0.35 μm, or 0.25-0.35 μm. Furthermore, the average particle size of the secondary particles of the secondary particle layer is preferably 0.34 μm or less, is preferably 0.33 μm or less, is preferably 0.32 μm or less, is preferably 0.31 μm or less, is preferably 0.30 μm or less, is preferably 0.29 μm or less, is preferably 0.28 μm or less, is preferably 0.27 μm or less, is preferably 0.26 μm or less, is preferably 0.25 μm or less, is preferably 0.24 μm or less, is more preferably 0.234 μm or less, is more preferably 0.23 μm or less, is more preferably 0.22 μm or less, is more preferably 0.21 μm or less, is more preferably 0.20 μm or less, is more preferably 0.19 μm or less, is more preferably 0.18 μm or less, is more preferably 0.17 μm or less, is more preferably 0.16 μm or less, is more preferably 0.15 μm or less, is more preferably 0.145 μm or less, is more preferably 0.14 μm or less, is more preferably 0.13 μm or less, is more preferably 0.125 μm or less, is more preferably 0.12 μm or less, is more preferably 0.11 μm or less, is more preferably 0.10 μm or less, is more preferably 0.09 μm or less, is more preferably 0.08 μm or less, is more preferably 0.07 μm or less, and is more preferably 0.06 μm or less. The lower limit of the average particle size of the secondary particles of the secondary particle layer does not need to be limited specifically, but the lower limit is typically 0.001 μm or more as an example, 0.003 μm or more as an example, 0.005 μm or more as an example, 0.007 μm or more as an example, 0.009 μm or more, or 0.01 μm or more. Note that in some base materials, sufficient adhesion strength can be secured only with the primary particles. In such a case, formation of the secondary particles may not be necessary.

The surface roughness Ra and Rz of the surface on the primary particle layer side of the copper foil, the average particle size of primary particles of the primary particle layer of the copper foil, and the average particle size of secondary particles of the secondary particle layer of the copper foil can be controlled by the surface roughness of the copper foil before forming the roughened layer and/or the forming conditions (plating conditions) of each of the primary particle layer and the secondary particle layer.

By increasing the surface roughness Ra (the surface roughness Ra in the TD direction (width direction) of the copper foil) of the copper foil and/or the surface roughness Rz (the surface roughness Rz in the TD direction (width direction) of the copper foil) of the copper foil before the roughened layer (surface treated layer) is formed, the surface roughness Ra (the surface roughness Ra in the TD direction (width direction) of the copper foil) of the surface on the primary particle layer of the copper foil and/or the surface roughness Rz (the surface roughness Rz in the TD direction (width direction) of the copper foil) of the surface on the primary particle layer of the copper foil and the average particle size of the primary particles and/or the average particle size of the secondary particles can be increased. By decreasing the surface roughness Ra (the surface roughness Ra in the TD direction (width direction) of the copper foil) of the copper

foil and/or the surface roughness Rz (the surface roughness Rz in the TD direction (width direction) of the copper foil) of the copper foil before the roughened layer (surface treated layer) is formed, the surface roughness Ra (the surface roughness Ra in the TD direction (width direction) of the copper foil) of the surface on the primary particle layer of the copper foil and/or the surface roughness Rz (the surface roughness Rz in the TD direction (width direction) of the copper foil) of the surface on the primary particle layer of the copper foil and the average particle size of the primary particles and/or the average particle size of the secondary particles can be decreased.

The surface roughness Ra in the TD direction (width direction) of the copper foil before the roughened layer (surface treated layer) is formed is preferably 0.10 μm or less, is preferably 0.09 μm or less, is preferably 0.08 μm or less, is preferably 0.07 μm or less, is preferably 0.06 μm or less, and is preferably 0.05 μm or less. This is because when the surface roughness Ra in the TD direction (width direction) of the copper foil before the roughened layer (surface treated layer) is formed is kept 0.10 μm or less, the surface roughness Ra (arithmetic mean roughness) in the TD direction of the surface on the primary particle layer side of the copper foil after the roughened layer (surface treated layer) is formed can be more easily controlled at 0.12 μm or less. The lower limit of the surface roughness Ra in the TD direction (width direction) of the copper foil before the roughened layer (surface treated layer) is formed does not need to be specifically limited, but the lower limit is typically 0.001 μm or more as an example, 0.005 μm or more as an example, 0.007 μm or more as an example, 0.01 μm or more as an example, 0.02 μm or more, 0.03 μm or more, 0.04 μm or more, or 0.05 μm or more.

The surface roughness Rz in the TD direction (width direction) of the copper foil before the roughened layer (surface treated layer) is formed is preferably 0.90 μm or less, is preferably 0.85 μm or less, is preferably 0.83 μm or less, is preferably 0.81 μm or less, is preferably 0.79 μm or less, is preferably 0.77 μm or less, is preferably 0.75 μm or less, is preferably 0.73 μm or less, is preferably 0.71 μm or less, and is preferably 0.69 μm or less. This is because when the surface roughness Rz in the TD direction (width direction) of the copper foil before the roughened layer (surface treated layer) is formed is kept 0.90 μm or less, the surface roughness Rz (ten point mean roughness) in the TD direction of the surface on the primary particle layer side of the copper foil after the roughened layer (surface treated layer) is formed can be more easily controlled at 1.60 μm or less. The lower limit of the surface roughness Rz in the TD direction (width direction) of the copper foil before the roughened layer (surface treated layer) is formed does not need to be specifically limited, but the lower limit is typically 0.001 μm or more as an example, 0.005 μm or more as an example, 0.007 μm or more as an example, 0.01 μm or more as an example, 0.02 μm or more, 0.03 μm or more, 0.04 μm or more, or 0.05 μm or more.

An example of the forming conditions (the composition of bath and plating conditions) for each of the primary particle layer and the secondary particle layer at the time of forming the above-described roughened layer is provided below.

[Composition of bath and plating conditions]

It is preferably that the primary particle layer is formed on the surface of the copper foil by forming a plated layer under the conditions of primary particle layer formation 1 (A-1), and afterwards by forming a plated layer under the conditions of primary particle layer formation 2 (A-2). Note that another layer or other layers may be provided between the primary particle layer and the copper foil. Such a layer (layers) may include a copper plated layer or a nickel plated layer.

(A-1) Primary particle layer formation 1 (Cu plating or Cu-W alloy plating)

The process of primary particle layer formation 1 is a process corresponding to roughening plating (rough plating). The roughening plating is a plating conducted by setting the current density to the current density limit or higher.

(Cu plating)

Composition of solution: copper 10-20 g/L, sulfuric acid 50-100 g/L
Temperature of solution: 25-50 °C
Current density: 20-58 A/ $dm^2$
Amount of coulomb: 30-80 As/ $dm^2$

(Cu-W alloy plating)

Composition of solution: copper 10-20 g/L, tungsten 0.1-30 mg/L, sulfuric acid 50-100 g/L
Temperature of solution: 25-50 °C
Current density: 20-58 A/ $dm^2$
Amount of coulomb: 30-80 As/ $dm^2$

(A-2) Primary particle layer formation 2

The process of primary particle layer formation 2 is a process corresponding to smooth plating (normal plating). The smooth plating is plating conducted by setting the current density to less than the current density limit.
Composition of solution: copper 15-50 g/L, sulfuric acid 60-100 g/L
Temperature of solution: 25-50 °C
Current density: 1-10 A/ $dm^2$
Amount of coulomb: 10-30 As/ $dm^2$

As described above, the primary particle layer forming process is conducted in multiple stages such as two stages, and the smooth plating is conducted in the following process. As a result, the surface roughness Ra of the surface of the primary particle layer side of the copper layer can be further reduced. Note that as the current density becomes low and/or as the amount of coulomb becomes large, the effect of reducing Ra may become greater.

It should be noted that one element or two or more elements selected from a group of Ni, Co, Fe, Cr, Mo, Zn, Ta, Al, P, W, Mn, Sn, As, and Ti may be added to the above-described plating solution used for forming the primary particles at a concentration of 0.0001-0.5 g/L for each element.

It should also be noted that the primary particle layer may be formed by the process conducted only once or by the process conducted twice or more.

(B) Secondary particle layer formation

The secondary particle layer can be formed under the following conditions. Note that the secondary particle layer may not be formed. The secondary particle layer may be formed by Cu-Co-Ni alloy plating, Cu-Co alloy plating, Cu-Ni alloy plating, Cu-Ni-P alloy plating, Cu-Ni-Mo-W alloy plating, Cu-Ni-Fe-Zn alloy plating, Cu-Co-Cr-Ti alloy plating, or Cu-Co-As alloy plating etc. The secondary particle layer may be formed by the process conducted only once or by the process conducted twice or more.

(Secondary particle layer forming condition 1)

An example of the plating conditions of the secondary particles is provided below.
Composition of solution: one element or two or more elements selected from a group of Ni, Co, Fe, Cr, Mo, Zn, Ta, Al, P, W, Mn, Sn, As, and Ti 0.001-15 g/L for each element pH: 2-3
Temperature of solution: 30-50 °C
Current density: 25-50 A/ $dm^2$
Amount of coulomb: 4-50 As/ $dm^2$, more preferably 5-40 As/ $dm^2$, more preferably 8-30 As/ $dm^2$

(Secondary particle layer forming condition 2)

An example of the plating conditions of the secondary particles is provided below.
Composition of solution: copper 10-20 g/L, one element or two or more elements selected from a group of Ni, Co, Fe, Cr, Mo, Zn, Ta, Al, P, W, Mn, Sn, As, and Ti 0.001-15 g/L for each element pH: 2-3
Temperature of solution: 30-50 °C
Current density: 25-50 A/ $dm^2$
Amount of coulomb: 4-50 As/ $dm^2$, more preferably 5-40 As/ $dm^2$, more preferably 8-30 As/ $dm^2$

(Cu-Co-Ni alloy plating)

Composition of solution: copper 10-20 g/L, nickel 5-15 g/L, cobalt 5-15 g/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Co alloy plating)

Composition of solution: copper 10-20 g/L, cobalt 5-15 g/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Ni alloy plating)

Composition of solution: copper 10-20 g/L, nickel 5-15 g/L, pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Ni-P alloy plating)

Composition of solution: copper 10-20 g/L, nickel 5-15 g/L, phosphorous 0.1-3 g/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Ni-Mo-W alloy plating)

Composition of solution: copper 10-20 g/L, nickel 5-15 g/L, molybdenum 0.5-8 g/L, tungsten 0.1-30 mg/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Ni-Fe-Zn alloy plating)

Composition of solution: copper 10-20 g/L, nickel 5-15 g/L, iron 0.1-1.5 g/L, zinc 0.5-5 g/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

(Cu-Co-Cr-Ti alloy plating)

Composition of solution: copper 10-20 g/L, cobalt 5-15 g/L, Chromium 0.1-1.5 g/L, titanium 0.01-1.5 g/L
pH: 2-3
Temperature of solution: 30-50 °C
Current density: 25-75 A/ $dm^2$
Amount of coulomb: 4-50 As/ $dm^2$, more preferably 5-40 As/ $dm^2$, more preferably 8-30 As/ $dm^2$

(Cu-Co-As alloy plating)

Composition of solution: copper 10-20 g/L, cobalt 5-15 g/L, arsenic 0.01-2 g/L
pH: 2-3
Temperature of solution: 30-50 °C
Current density: 25-50 A/ $dm^2$
Amount of coulomb: 4-75 As/ $dm^2$, more preferably 5-40 As/ $dm^2$, more preferably 8-30 As/ $dm^2$

For example, as the roughening treatment at the time of forming the above-described primary particle layer or secondary particle layer, Cu-Co-Ni alloy plating can be carried out. The Cu-Co-Ni alloy plating can be carried out by electrolytic plating. In the Cu-Co-Ni alloy plated layer, the deposition amount of Cu can be 15-40 mg/$dm^2$, the deposition amount of Co can be 100-3000 $\mu$g/$dm^2$, and the deposition amount of Ni can be 100-1500 $\mu$g/$dm^2$. The Cu-Co-Ni alloy plated layer can be a ternary alloy layer of Cu, Co, and Ni having the deposition amount described above. When the deposition amount of Co is less than 100 $\mu$g/$dm^2$, heat resistance may be degraded, and etching performance may be deteriorated. When the deposition amount of Co exceeds 3000 $\mu$g/$dm^2$, the resultant alloy is not favorable in a case in which a magnetic influence needs to be considered, etching stains may be caused, and acid resistivity and chemical resistance may be degraded. When the deposition amount of Ni is less than 100 $\mu$g/$dm^2$, heat resistance may be degraded. On the other hand, when the deposition amount of Ni exceeds 1500 $\mu$g/$dm^2$, etching residues may be increased. The preferable deposition amount of Co is 100-2500 $\mu$g/$dm^2$, and the preferable deposition amount of Ni is 100-1200 $\mu$g/$dm^2$. Here, the etching stain refers to Co that remains undissolved when the etching is performed with copper chloride, and the etching residue refers to Ni that remains undissolved when the alkali etching is performed with ammonium chloride.

It should be noted that at the time of forming the primary particle layer, by having a longer plating time and/or by having a lower current density and/or by having a larger amount of coulomb, the average particle size of the primary particles can be made larger. On the other hand, at the time of forming the primary particle layer, by having a shorter plating time and/or by having a higher current density and/or by having a smaller amount of coulomb and/or by adding a prescribed element(s) described later to the plating solution, the average particle size of the primary particles can be made smaller.

It should also be noted that at the time of forming the secondary particle layer, by having a longer plating time and/or by having a higher current density and/or by having a larger amount of coulomb, the average particle size of the secondary particles can be made larger. On the other hand, at the time of forming the secondary particle layer, by having a shorter plating time and/or by having a lower current density and/or by having a smaller amount of coulomb and/or by adding a prescribed element (s) described later to the plating solution, the average particle size of the secondary particles can be made smaller.

Note that the arithmetic mean roughness Ra and the ten point mean roughness Rz of the copper foil surface or the ultra-thin copper layer surface before a surface treatment such as a roughening treatment can be controlled as below.

When a rolled copper foil is used, the arithmetic mean roughness Ra of the surface of mill rolls used in the final cold rolling is set to be 0.14 $\mu$m or less. By reducing the arithmetic mean roughness Ra of the surface of mill rolls used in the final cold rolling, the arithmetic mean roughness Ra of the copper foil surface before a surface treatment such as a roughening treatment can be made smaller. By increasing the arithmetic mean roughness Ra of the surface of mill rolls used in the final cold rolling, the arithmetic mean roughness Ra of the copper foil surface before a surface treatment such as a roughening treatment can be made larger. The oil film equivalent amount at the time of the final cold rolling is set to be 12000-26000. By reducing the oil film equivalent amount at the time of the final cold rolling, the arithmetic mean roughness Ra and/or the ten point mean roughness Rz of the copper foil surface before a surface treatment such as a roughening treatment can be made smaller. By increasing the oil film equivalent amount at the time of the final cold rolling, the arithmetic mean roughness Ra and/or the ten point mean roughness Rz of the copper foil surface before a surface treatment such as a roughening treatment can be made larger.

The oil film equivalent amount is expressed by the following equation.

$$(\text{oil film equivalent amount}) = \{(\text{viscosity of rolling oil [cSt]}) \times (\text{rolling speed [mpm]} + \text{rolling peripheral velocity [mpm]})\} / \{(\text{bite angle of roll [rad]}) \times (\text{yield stress of material [kg/mm}^2\text{]})\}$$

The viscosity of rolling oil [cSt] is the kinetic viscosity at 40 °C.

It should be noted that when an electrolytic copper foil is used, by reducing the arithmetic mean roughness Ra and/or the ten point mean roughness Rz of the surface of the cathode drum (electrolytic drum) used at the time of manufacturing the electrolytic copper foil, the arithmetic mean roughness Ra and/or the ten point mean roughness Rz of a shiny face (S face) of the electrolytic copper foil can be made smaller. By increasing the arithmetic mean roughness Ra and/or the ten point mean roughness Rz of the surface of the cathode drum (electrolytic drum) used at the time of manufacturing the electrolytic copper foil, the arithmetic mean roughness Ra and/or the ten point mean roughness Rz of the shiny face of the electrolytic copper foil can be made larger. In addition, by adding a gloss agent or a leveling agent and/or chloride ion to the electrolyte used at the time of manufacturing the electrolytic copper foil, the arithmetic mean roughness Ra and/or the ten point mean roughness Rz of the deposited face (matt face or M face) and/or the shiny face (S face) of the electrolytic copper foil can be made smaller. For the gloss agent and the leveling agent, gloss agents and leveling agents known in the art, or the leveling agent described later can be used.

For an ultra-thin copper layer of the carrier-attached copper foil, by controlling Ra and Rz of the surface of the copper foil used as a carrier by the above-described methods, Ra and Rz of the ultra-thin copper layer surface can be controlled. Ra and Rz of the ultra-thin copper layer surface can also be controlled by adding a leveling agent and chloride ion described later to the electrolyte used at the time of forming the ultra-thin copper layer. More specifically, by increasing the concentration of the leveling agent and/or the concentration of chloride ion in the electrolyte used at the time of forming the ultra-thin copper layer, the value(s) of Ra and/or Rz of the ultra-thin copper layer surface can be made smaller. By reducing the concentration of the leveling agent and/or the concentration of chloride ion in the electrolyte used at the time of forming the ultra-thin copper layer, the value(s) of Ra and/or Rz of the ultra-thin copper layer surface can be made larger.

The total content of Co and Ni in the roughened layer is preferably 2000 $\mu g/dm^2$. By keeping the total content of Co and Ni 2000 $\mu g/dm^2$ or less in the roughened layer, the conductor loss may be reduced, and a more favorable high frequency characteristic may be developed. The total content of Co and Ni in the roughened layer is more preferably 1900 $\mu g/dm^2$ or less, is more preferably 1800 $\mu g/dm^2$ or less, is more preferably 1700 $\mu g/dm^2$ or less, is more preferably 1600 $\mu g/dm^2$ or less, is more preferably 1500 $\mu g/dm^2$ or less, is more preferably 1400 $\mu g/dm^2$ or less, is more preferably 1300 $\mu g/dm^2$ or less, is more preferably 1200 $\mu g/dm^2$ or less, is more preferably 1100 $\mu g/dm^2$ or less, is furthermore preferably 1000 $\mu g/dm^2$ or less, is furthermore preferably 950 $\mu g/dm^2$ or less, is furthermore preferably 900 $\mu g/dm^2$ or less, is furthermore preferably 850 $\mu g/dm^2$ or less, is furthermore preferably 800 $\mu g/dm^2$ or less, is furthermore preferably 750 $\mu g/dm^2$ or less, and is furthermore preferably 700 $\mu g/dm^2$ or less. The lower limit of the total content of Co and Ni in the roughened layer does not need to be limited specifically, but the lower limit is typically 0 $\mu g/dm^2$ or, in other words, the roughened layer does not contain Co or Ni as an example, or the lower limit is typically 0 $\mu g/dm^2$ or more as an example, 0.1 $\mu g/dm^2$ or more as an example, 0.5 $\mu g/dm^2$ or more as an example, 0.8 $\mu g/dm^2$ or more as an example, 1 $\mu g/dm^2$ or more as an example, 2 $\mu g/dm^2$ or more as an example, 5 $\mu g/dm^2$ or more as an example, 10 $\mu g/dm^2$ or more as an example, 15 $\mu g/dm^2$ or more as an example, 20 $\mu g/dm^2$ or more as an example, and 25 $\mu g/dm^2$ or more as an example.

Moreover, the content of Co in the roughened layer is preferably 1000 $\mu g/dm^2$ or less. By keeping the content of Co 1000 $\mu g/dm^2$ or less in the roughened layer, the conductor loss may be reduced, and a more favorable high frequency characteristic may be developed. The content of Co in the roughened layer is preferably 950 $\mu g/dm^2$ or less, is preferably 900 $\mu g/dm^2$ or less, is preferably 850 $\mu g/dm^2$ or less, is preferably 800 $\mu g/dm^2$ or less, is preferably 750 $\mu g/dm^2$ or less, is preferably 700 $\mu g/dm^2$ or less, is preferably 650 $\mu g/dm^2$ or less, is preferably 600 $\mu g/dm^2$ or less, is preferably 550 $\mu g/dm^2$ or less, and is preferably 500 $\mu g/dm^2$ or less. The lower limit of the content of Co in the roughened layer does not need to be limited specifically, but the lower limit is typically 0 $\mu g/dm^2$ or, in other words, the roughened layer does not contain Co as an example, or the lower limit is typically 0 $\mu g/dm^2$ or more as an example, 0.1 $\mu g/dm^2$ or more as an example, 0.5 $\mu g/dm^2$ or more as an example, 0.8 $\mu g/dm^2$ or more as an example, 1 $\mu g/dm^2$ or more as an example, 2 $\mu g/dm^2$ or more as an example, 5 $\mu g/dm^2$ or more as an example, 8 $\mu g/dm^2$ or more as an example, 10 $\mu g/dm^2$ or more as an example, 11 $\mu g/dm^2$ or more as an example, and 15 $\mu g/dm^2$ or more as an example.

Furthermore, the content of Ni in the roughened layer is preferably 1000 $\mu g/dm^2$ or less. By keeping the content of Ni 1000 $\mu g/dm^2$ or less in the roughened layer, the conductor loss may be reduced, and a more favorable high frequency characteristic may be developed. The content of Ni in the roughened layer is preferably 950 $\mu g/dm^2$ or less, is preferably 900 $\mu g/dm^2$ or less, is preferably 850 $\mu g/dm^2$ or less, is preferably 800 $\mu g/dm^2$ or less, is preferably 750 $\mu g/dm^2$ or less, is preferably 700 $\mu g/dm^2$ or less, is preferably 650 $\mu g/dm^2$ or less, is preferably 600 $\mu g/dm^2$ or less, is preferably 550 $\mu g/dm^2$ or less, and is preferably 500 $\mu g/dm^2$ or less. The lower limit of the content of Ni in the roughened layer does not need to be limited specifically, but the lower limit is typically 0 $\mu g/dm^2$ or, in other words, the roughened layer does not contain Ni as an example, or the lower limit is typically 0 $\mu g/dm^2$ or more as an example, 0.1 $\mu g/dm^2$ or more as an example, 0.5 $\mu g/dm^2$ or more as an example, 0.8 8 $\mu g/dm^2$ or more as an example, 1 $\mu g/dm^2$ or more as an example, 2 $\mu g/dm^2$ or more as an example, 5 $\mu g/dm^2$ or more as an example, 8 $\mu g/dm^2$ or more as an example, 10 $\mu g/dm^2$ or more as an example, 11 $\mu g/dm^2$ or more as an example, and 15 $\mu g/dm^2$ or more as an example.

It should be noted that when the copper foil has additional surface treated layer (s) other than a roughened layer, the total content of Co and Ni in the roughened layer refers to the total content of Co and Ni in the roughened layer and Co and Ni in the surface treated layer(s) other than the roughened layer. In the above case, the content of Co in the roughened layer refers to the total content of Co in the roughened layer and Co in the surface treated layer(s) other than the roughened layer. In the above case, the content of Ni in the roughened layer refers to the total content of Ni in the roughened layer and Ni in the surface treated layer (s) other than the roughened layer. The surface treated layer(s) other than the roughened layer include(s) a heat-resistant layer, a rustproofing layer, a chromate treated layer, and a silane coupling-treated layer etc.

Each of the primary particle layer and the secondary particle layer can be formed from an electroplated layer. The characteristic of the secondary particles is one or plural dendritic particles grown on the primary particles or normal plating grown on the primary particle. In other words, when the term "secondary particle layer" is used in the present specification, a normal plating layer such as cover plating is also included. In addition, the secondary particle layer may be a layer having one or more layers formed of roughening particles, a layer having one or more normal plating layers, or a layer having one or more layers formed of roughening particles and one or more normal plating layers.

It should be noted that the primary particle layer is a layer including roughening particles formed directly on the copper foil and roughening particles that are layered on the roughening particles and that have a composition similar to the composition of the roughening particles formed directly on the copper foil or have the same element(s) as the element(s) contained in the roughening particles formed directly on the copper foil. The secondary particle layer is a layer including roughening particles that are formed over the roughening particle included in the primary particle layer and that have a composition different from the composition of the roughening particles forming the primary particle layer or have any element(s) that the roughening particles forming the primary particle layer do not have.

When the above-described element(s) forming the primary particles and/or secondary particles cannot be measured, and/or when the concentration or the deposition amount of the above-described element(s) cannot be measured, the primary particles and the secondary particles can be determined in such a manner that when particles are observed in a scanning electron microscope photograph, particles that are not overlapped with other particles and particles that are overlapped with other particles and are positioned on the copper foil side of (or under) the other particles are regarded as the primary particles and particle that are overlapped with other particles and are positioned over the other particles are regarded as the secondary particles.

It is preferable that the primary particle layer includes copper. It is preferable that the primary particle layer is formed from metal containing copper as a maj or component. Here, the major component is an element that takes up 50 wt% or higher of the concentration in the primary particle layer. It is preferable that the primary particle layer is made from copper and inevitable impurity. This is because when the primary particle layer includes copper, the conductor loss of the copper foil may be reduced. The primary particle layer may contain one element or two or more elements selected from a group of Ni, Co, Fe, Cr, Mo, Zn, Ta, Cu, Al, P, W, Mn, Sn, As and Ti.

The secondary particle layer preferably contains one element or two or more elements selected from a group of Ni, Co, Fe, Cr, Mo, Zn, Ta, Cu, Al, P, W, Mn, Sn, As and Ti. The secondary particle layer preferably contains Cu and one element or two or more elements selected from a group of Ni, Co, Fe, Cr, Mo, Zn, Ta, Cu, Al, P, W, Mn, Sn, As and Ti. The secondary particle layer preferably contains an alloy. The secondary particle layer preferably contains an alloy containing one element or two or more elements selected from a group of Ni, Co, Fe, Cr, Mo, Zn, Ta, Cu, Al, P, W, Mn, Sn, As and Ti. The secondary particle layer preferably contains Cu and an alloy containing one element or two or more elements selected from a group of Ni, Co, Fe, Cr, Mo, Zn, Ta, Cu, Al, P, W, Mn, Sn, As and Ti. When the secondary particle layer contains the above-described element (s) or alloy, the size of the secondary particles in the secondary particle layer may become smaller. When the size of the secondary particles in the secondary particle layer is smaller, the conductor loss of the copper foil may be reduced.

<Transmission loss>

When transmission loss is small, because signal attenuation at the time of signal transmission at a high frequency is controlled, in a circuit that transmits signals at a high frequency, stable signal transmission can be realized. For that reason, a smaller value of transmission loss in a circuit using a copper foil is preferable and such a copper foil is therefore suitable for use in a circuit that transmits signals at a high frequency. When a circuit is formed by attaching a resin (a liquid crystal polymer resin or a PTFE substrate (fluororesin substrate) or a COP substrate (cyclo-olefin polymer substrate) or a low dielectric PI resin (low dielectric polyimide resin)) having the dielectric constant of 2.9, the dielectric tangent of 0.002, and the thickness of 50 μm to a surface on the roughened layer side of the copper foil, by making the thickness of the copper foil be 18 μm, and by etching the copper foil so that a characteristic impedance of the circuit is 50 Ω, and the transmission loss is measured at the frequency of 60 GHz, the transmission loss is preferably 8.4 dB/10cm or less, is more preferably 8.3 dB/10cm or less, or is furthermore preferably 8.15 dB/10cm or less. Note that the copper foil used here is not limited to 18 μm thick. By performing copper plating for a copper foil thinner than 18 μm or by performing

soft etching for a thicker copper foil, similar measurements can be carried out.

When a circuit is formed by attaching a resin (a liquid crystal polymer resin or a PTFE substrate (fluororesin substrate) or a COP substrate (cyclo-olefin polymer substrate) or a low dielectric PI resin (low dielectric polyimide resin)) having the dielectric constant of 3.2, the dielectric tangent of 0.002, and the thickness of 50 μm to a surface on the roughened layer side of the copper foil, by making the thickness of the copper foil be 18 μm, and by etching the copper foil so that a characteristic impedance of the circuit is 50 Ω, and the transmission loss is measured at the frequency of 60 GHz, the transmission loss is preferably 8.4 dB/10cm or less, is more preferably 8.3 dB/10cm or less, or is furthermore preferably 8.15 dB/10cm or less. Note that the copper foil used here is not limited to 18 μm thick. By performing copper plating for a copper foil thinner than 18 μm or by performing soft etching for a thicker copper foil, similar measurements can be carried out.

When a circuit is formed by attaching a resin (a liquid crystal polymer resin or a PTFE substrate (fluororesin substrate) or a COP substrate (cyclo-olefin polymer substrate) or a low dielectric PI resin (low dielectric polyimide resin)) having the dielectric constant of 2.4, the dielectric tangent of 0.001, and the thickness of 50 μm to a surface on the roughened layer side of the copper foil, by making the thickness of the copper foil be 18 μm, and by etching the copper foil so that a characteristic impedance of the circuit is 50 Ω, and the transmission loss is measured at the frequency of 60 GHz, the transmission loss is preferably 8.4 dB/10cm or less, is more preferably 8.3 dB/10cm or less, or is furthermore preferably 8.15 dB/10cm or less. Note that the copper foil used here is not limited to 18 μm thick. By performing copper plating for a copper foil thinner than 18 μm or by performing soft etching for a thicker copper foil, similar measurements can be carried out.

After the copper foil according to the present invention is attached to an insulating substrate, a target conductor pattern is etched into the copper foil, and eventually a printed wiring board can be manufactured.

<Carrier-attached copper foil>

The carrier-attached copper foil according to the present invention has an intermediate layer and an ultra-thin copper layer in this order on one or both of surfaces of the carrier. This ultra-thin copper layer is the copper foil described above as one of the embodiments of the present invention.

<Carrier>

The carrier that can be used in the present invention is usually a metal foil or a resin film and is provided in the form of, for example, a copper foil, a copper alloy foil, a nickel foil, a nickel alloy foil, an iron foil, an iron alloy foil, a stainless foil, an aluminum foil, an aluminum alloy foil, an insulating resin film, a polyimide film, an LCP (liquid crystal polymer) film, a fluororesin film, a polyethylene terephthalate (PET) film, a polypropylene (PP) film, a polyamide film, and a polyamide-imide film.

The carrier that can be used in the present invention is usually provided in the form of a rolled copper foil or an electrolytic copper foil. In general, an electrolytic copper foil is manufactured by copper sulfate plating bath and electrolytic deposition of copper on a titanium or stainless drum, and a rolled copper foil is manufactured by repeating plastic working and heat treatment using a mill roll. Materials of the copper foil may include a highly pure copper such as a tough pitch copper (JIS H3100: alloy number C1100) and an oxygen-free copper (JIS H3100: alloy number C1020 or JIS H3510; alloy number C1011), and in addition, a copper containing Sn, a copper containing Ag, and a copper alloy such as a Cr, Zr or Mg-added copper alloy and a Ni and Si-added Corson copper alloy can also be used. Note that when the term "copper foil" is used alone in this specification, the term includes a copper alloy foil.

The thickness of the carrier that can be used in the present invention is not particularly limited, but the thickness may be appropriately adjusted so as to be suitable to function as a carrier and can be 5 μm or thicker as an example. However, when the carrier is too thick, production cost increases, and therefore the thickness is preferably 35 μm or thinner in general. Accordingly, the thickness of the carrier is typically 8-70 μm, is more typically 12-70 μm, and is more typically 18-35 μm. From the perspective of reducing raw material cost, it is preferable to have a thinner carrier. For that reason, the thickness of the carrier is typically 5 μm or thicker and 35 μm or thinner, is preferably 5 μm or thicker and 18 μm or thinner, is preferably 5 μm or thicker and 12 μm or thinner, is preferably 5 μm or thicker and 11 μm or thinner, or is preferably 5 μm or thicker and 10 μm or thinner. Note that a thin carrier is easily creased when the carrier is passed through a processing machine. In order to prevent the carrier from getting creases, it is effective to smoothen feed rolls or to shorten a distance between feed rolls in a carrier-attached copper foil manufacturing apparatus as an example. Note that when a carrier-attached copper foil is used in the embedded process that is one of manufacturing methods of printed wiring boards, the carrier needs to have high rigidity. For that reason, when a carrier-attached copper foil is used in the embedded process, the thickness of the carrier is preferably 18 μm or thicker and 300 μm or thinner, is preferably 25 μm or thicker and 150 μm or thinner, is preferably 35 μm or thicker and 100 μm or thinner, or is more preferably 35 μm or thicker and 70 μm or thinner.

It should be noted that the roughened layer may be provided on a surface opposite to the surface on which the ultra-thin copper layer of the carrier is provided. Such a roughened layer may be provided by using a known method, or may be provided by the roughening treatment described later. Providing the roughened layer on the surface opposite to the surface on which the ultra-thin copper layer of the carrier is provided-has such an advantage that the carrier and the resin substrate are not easily detached from each other at the time of laminating the carrier on a support such as a resin substrate so that a surface that has the roughened layer faces the support.

An example of manufacturing conditions when an electrolytic copper foil is used as the carrier is provided below.

<Composition of electrolyte>

Copper: 90-110 g/L
Sulfuric acid: 90-110 g/L
Chloride: 50-100 ppm
Leveling agent 1 (bis(3-sulfopropyl)-disulfide): 10-30 ppm
Leveling agent 2 (amine compound): 10-30 ppm

The amine compound expressed by the following formula can be used for the above amine compound.

It should be noted that in the treatment solutions used for electrolysis, surface treatments, or plating etc. employed in the present invention, the balance is water unless otherwise stated.

[Formula 1]

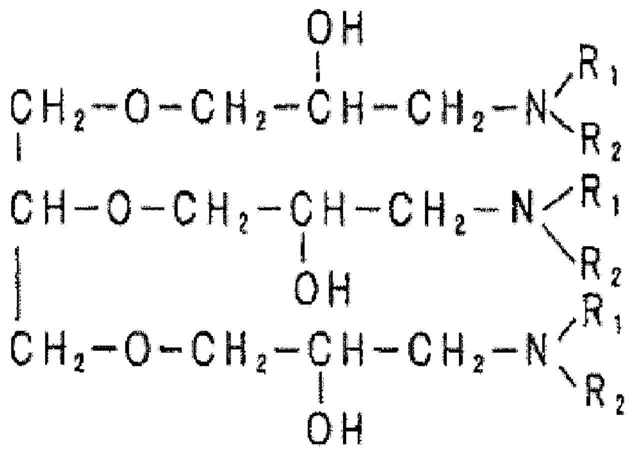

(In the above formula, each of $R_1$ and $R_2$ is selected from a group of a hydroxyalkyl group, an ether group, an aryl group, an aromatic-substituted alkyl group, an unsaturated hydrocarbon group, and an alkyl group.)

<Manufacturing conditions>

Current density: 70-100 A/dm$^2$
Temperature of electrolyte: 50-60 °C
Electrolyte linear flow rate: 3-5 m/sec
Electrolysis time: 0.5-10 minutes

<Intermediate layer>

An intermediate layer is provided on the carrier. Another layer or other layers may be provided between the carrier and the intermediate layer. The intermediate layer to be used in the present invention is not particularly limited as long as the ultra-thin copper layer is not easily detached from the carrier before the carrier-attached copper foil is laminated on an insulating substrate; whereas the ultra-thin copper layer is easily detached from the carrier after the

carrier-attached copper foil is laminated on an insulating substrate. The intermediate layer of the carrier-attached copper foil of the present invention may contain, for example, one or two and more selected from a group consisting of Cr, Ni, Co, Fe, Mo, Ti, W, P, Cu, Al, Zn, an alloy of any of these elements, a hydrate of any of these elements, an oxide of any of these elements and an organic compound. Furthermore, the intermediate layer may be formed of a single layer or a plurality of layers.

For example, the intermediate layer can be composed by forming from the carrier side a single metal layer formed of a single element selected from a group of elements consisting of Cr, Ni, Co, Fe, Mo, Ti, W, P, Cu, Al and Zn or an alloy layer formed of at least one element selected from a group of elements consisting of Cr, Ni, Co, Fe, Mo, Ti, W, P, Cu, Al and Zn, and by forming over the single metal layer or the alloy layer, a layer formed of a hydrate or an oxide of at least one element selected from the a group of elements consisting of Cr, Ni, Co, Fe, Mo, Ti, W, P, Cu, Al and Zn, a layer formed of an organic compound, or a single metal layer formed of a single element of a group of elements selected from a group of elements consisting of Cr, Ni, Co, Fe, Mo, Ti, W, P, Cu, Al and Zn, or an alloy layer formed of at least one element selected from a group of elements consisting of Cr, Ni, Co, Fe, Mo, Ti, W, P, Cu, Al and Zn.

In the case where the intermediate layer is provided only one of the surfaces of the carrier, it is preferably to provide a rustproofing layer such as a Ni-plated layer on the opposite surface of the carrier. Note that, in the case where the intermediate layer is provided by a chromate treatment, a zinc-chromate treatment or plating, it is believed that a part of attached metal such as chromium or zinc could form a hydrate or oxide in some cases.

The intermediate layer can be formed, for example, by laminating, on the carrier, nickel, a nickel-phosphorus alloy or a nickel-cobalt alloy and chromium in this order from the carrier. Since the bonding strength between nickel and copper is higher than the bonding strength between chromium and copper, when the ultra-thin copper layer is detached, the ultra-thin copper layer can be detached at the interface between the ultra-thin copper layer and the chromium. The nickel contained in the intermediate layer is expected to exert a barrier effect that prevents diffusion of a copper component of the carrier into the ultra-thin copper layer. The deposition amount of nickel in the intermediate layer is preferably 100 $\mu g/dm^2$ or more and 40000 $\mu g/dm^2$ or less, is more preferably 100 $\mu g/dm^2$ or more and 4000 $\mu g/dm^2$ or less, is more preferably 100 $\mu g/dm^2$ or more and 2500 $\mu g/dm^2$ or less, and is more preferably 100 $\mu g/dm^2$ or more and less than 1000 $\mu g/dm^2$. The deposition amount of chromium in the intermediate layer is preferably 5 $\mu g/dm^2$ or more and 100 $\mu g/dm^2$ or less.

<Ultra-thin copper layer>

An ultra-thin copper layer is provided on the intermediate layer. Another layer or other layers may be provided between the intermediate layer and the ultra-thin copper layer. The ultra-thin copper layer can be formed by electroplating utilizing an electrolytic bath of copper sulfate, copper pyrophosphate, copper sulfamate, copper cyanide, etc. A copper sulfate bath is preferred because it is used for general electrolytic copper foils, and it enables formation of copper foils at high current densities. The thickness of the ultra-thin copper layer is not particularly limited, but the ultra-thin copper layer is generally thinner than the carrier, and an example is 12 $\mu m$ or less. The thickness is typically 0.5 to 12 $\mu m$, is more typically 1 to 5 $\mu m$, is furthermore typically 1.5 to 5 $\mu m$ and is furthermore typically 2 to 5 $\mu m$. Note that the ultra-thin copper layer may be provided on both surfaces of the carrier.

In the above-described manner, a carrier-attached copper foil having a carrier, an intermediate layer laminated on the carrier, and an ultra-thin copper layer laminated on the intermediate layer is manufactured.

Methods of using carrier-attached copper foils per se are well-known to those skilled in the art. For example, the surface of the ultra-thin copper layer is attached and thermocompression bonded to an insulating substrate such as a paper based phenol resin, a paper based epoxy resin, a synthetic fiber cloth-based epoxy resin, a glass cloth/paper composite based epoxy resin, a glass cloth/non-woven glass cloth composite based epoxy resin and a glass cloth based epoxy resin, a polyester film and a polyimide film, and afterwards the carrier is detached so that a copper-clad laminate is formed. The ultra-thin copper layer adhered to the insulating substrate is etched into a target conductor pattern, and finally, a printed wiring board can be manufactured.

<Surface treatment>

After the roughening treatment, a heat-resistant layer or a rustproofing layer of any one element of Ni, Co, Cu, and Zn or an alloy of Ni, an alloy of Co, an alloy of Cu, an alloy of Zn or an alloy containing one or more elements selected from a group of Ni, Co, Cu, and Zn may be formed, and furthermore, a chromate treatment or a silane coupling treatment may be applied over the surface. In other words, one or more layer selected from a group of a heat-resistant layer, a rustproofing layer, a chromate treated layer, and a silane coupling-treated layer may be formed on the surface of the roughened layer. Note that each of the above-described heat-resistant layer, rustproofing layer, chromate treated layer, and silane coupling-treated layer may be formed from plural layers (e.g., two layers or more, three layer or more).

The chromate treated layer refers to a layer treated with a liquid including chromic acid anhydride, chromic

acid, dichromic acid, chromate, or dichromate. The chromate treated layer may contain an element (in any form such as metal, alloy, oxide, nitride, and sulfide) of Co, Fe, Ni, Mo, Zn, Ta, Cu, Al, P, W, Sn, As and Ti etc. Specific examples of the chromate treated layer include a chromate treated layer which is treated with chromic acid anhydride or a potassium dichromate aqueous solution and a chromate treated layer treated with chromic acid anhydride or a treatment liquid containing zinc and potassium dichromate.

The silane coupling-treated layer may be formed using a silane coupling agent known in the art, or may be formed using a silane coupling agent including epoxy silanes, amino silanes, methacryloxy silanes, mercapto silanes, vinyl silanes, imidazole silanes, triazine silanes, etc. Note that for such a silane coupling agent, two or more kinds of agents may be mixed for use. In particular, an agent that is made by using an amino silane coupling agent or an epoxy silane coupling agent is preferable.

A surface treatment described in International Publication No. WO2008/053878, Japanese Patent Laid-Open Application No. 2008-111169, Japanese Patent No. 5024930, International Publication No. WO2006/028207, Japanese Patent No. 4828427, International Publication No. WO2006/134868, Japanese Patent No. 5046927, International Publication No. WO2007/105635, Japanese Patent No. 5180815, and Japanese Patent Laid-Open Application No. 2013-19056 can be applied to a surface of the ultra-thin copper layer, the roughened layer, the heat-resistant layer, the rustproofing layer, the silane coupling-treated layer or the chromate treated layer.

<Resin layer>

The copper foil may be provided with a resin layer on a surface on the roughened layer side. The resin layer may be an adhesive layer and may be an insulating resin layer in a semi-cured state (B-stage), serving as an adhesive. The semi-cured state (B-stage) include a state where the surface thereof is not sticky when touched by a finger, the insulating resin layers of this state can be laminated and stored, and a curing reaction proceeds when a heating treatment is further applied.

The resin layer may contain a thermosetting resin or may be formed of a thermoplastic resin. The resin layer may contain a thermoplastic resin. The type of resin forming the resin layer is not particularly limited but is preferably a resin including at least one selected from the group consisting of an epoxy resin, a polyimide resin, a polyfunctional cyanate compound, a maleimide compound, a polymaleimide compound, a maleimide resin, an aromatic maleimide resin, a polyvinyl acetal resin, a urethane resin, polyether sulfone, a polyether sulfone resin, an aromatic polyamide resin, an aromatic polyamide resin polymer, a rubber resin, a polyamine, an aromatic polyamine, a polyamide-imide resin, a rubber modified epoxy resin, a phenoxy resin, a carboxyl group-modified acrylonitrile-butadiene resin, a polyphenylene oxide, a bismaleimide triazine resin, a thermosetting polyphenylene oxide resin, a cyanate ester resin, an anhydride of a carboxylic acid, an anhydride of a polybasic carboxylic acid, a linear polymer having a crosslinkable functional group, a polyphenylene ether resin, 2,2-bis(4-cyanatophenyl)propane, a phosphorus-containing phenol compound, manganese naphthenate, 2,2-bis(4-glycidylphenyl)propane, a polyphenylene ether-cyanate resin, a siloxane-modified polyamide-imide resin, a cyano ester resin, a phosphazene resin, a rubber-modified polyamide-imide resin, isoprene, a hydrogenated polybutadiene, polyvinyl butyral, phenoxy, a polymer epoxy, an aromatic polyamide, a fluorine resin, a bisphenol, a polyimide block copolymer resin and a cyano ester resin.

The epoxy resin has two or more epoxy groups in a molecule. Any epoxy resin can be used without problems as long as it can be used as an electrical/electron material. An epoxy resin obtained by epoxylating a compound having two or more glycidyl groups in a molecule is preferable. As the epoxy resin, a single resin selected from a group consisting of a bisphenol A type epoxy resin, a bisphenol F type epoxy resin, a bisphenol S type epoxy resin, a bisphenol AD type epoxy resin, a Novolak type epoxy resin, a cresol Novolak type epoxy resin, an alicyclic epoxy resin, a brominated epoxy resin, a phenol Novolak type epoxy resin, a naphthalene type epoxy resins, a brominated bisphenol A type epoxy resin, an o-cresol Novolak type epoxy resin, a rubber-modified bisphenol A type epoxy resin, a glycidyl amine type epoxy resin, triglycidyl isocyanurate, a glycidyl amine compound such as a N,N-diglycidylaniline, glycidyl ester compound such as diglycidyl tetrahydrophthalate, a phosphorus-containing epoxy resin, a biphenyl type epoxy resin, a biphenyl Novolak type epoxy resin, a trishydroxyphenylmethane type epoxy resin and a tetraphenyl ethane epoxy resin, may be used, or two or more resins selected from the above group are used as a mixture. Alternatively, a hydrogenated or halogenated form of these epoxy resins can be also used.

As the phosphorus-containing epoxy resin, a phosphorus-containing epoxy resin known in the art can be used. The phosphorus-containing epoxy resin is preferably an epoxy resin derived from, a compound having two or more epoxy groups in a molecule such as 9,10-dihydro-9-oxa-10-phospha-phenanthrene-10-oxide.

The resin layer may contain a resin known in the art, a resin curing agent, a compound, a curing accelerator, a dielectric substance (any dielectric substance may be used such as a dielectric substance containing an inorganic compound and/or an organic compound and a dielectric substance containing a metal oxide), a reaction catalyst, a crosslinking agent, a polymer, a prepreg and a skeletal material. Furthermore, the resin layer may be formed by using the substances (such as resins, resin curing agents, compounds, curing accelerator, a dielectric substance, reaction

catalyst, crosslinking agent, a polymer, a prepreg and a skeletal material) and/or a method for forming a resin layer and/or a forming apparatus that are described, for example, in International Publication No. WO2008/004399, International Publication No. WO2008/053878, International Publication No. WO2009/084533, Japanese Patent Laid-Open Application No. 11-5828, Japanese Patent Laid-Open Application No. 11-140281, Japanese Patent No. 3184485, International Publication No. WO97/02728, Japanese Patent No. 3676375, Japanese Patent Laid-Open Application No. 2000-43188, Japanese Patent No. 3612594, Japanese Patent Laid-Open Application No. 2002-179772, Japanese Patent Laid-Open Application No. 2002-359444, Japanese Patent Laid-Open Application No. 2003-304068, Japanese Patent No. 3992225, Japanese Patent Laid-Open Application No. 2003-249739, Japanese Patent No. 4136509, Japanese Patent Laid-Open Application No. 2004-82687, Japanese Patent No. 4025177, Japanese Patent Laid-Open Application No. 2004-349654, Japanese Patent No. 4286060, Japanese Patent Laid-Open Application No. 2005-262506, Japanese Patent No. 4570070, Japanese Patent Laid-Open Application No. 2005-53218, Japanese Patent No. 3949676, Japanese Patent No. 4178415, International Publication No. WO2004/005588, Japanese Patent Laid-Open Application No. 2006-257153, Japanese Patent Laid-Open Application No. 2007-326923, Japanese Patent Laid-Open Application No. 2008-111169, Japanese Patent No. 5024930, International Publication No. WO2006/028207, Japanese Patent No. 4828427, Japanese Patent Laid-Open Application No. 2009-67029, International Publication No. WO2006/134868, Japanese Patent No. 5046927, Japanese Patent Laid-Open Application No. 2009-173017, International Publication No. WO2007/105635, Japanese Patent No. 5180815, International Publication No. WO2008/114858, International Publication No. WO2009/008471, Japanese Patent Laid-Open Application No. 2011-14727, International Publication No. WO2009/001850, International Publication No. WO2009/145179, International Publication No. WO2011/068157 and Japanese Patent Laid-Open Application No. 2013-19056.

The above-described resins are dissolved in a solvent such as methyl ethyl ketone (MEK) and toluene to obtain a resin liquid, and the resin liquid is applied on the ultra-thin copper layer, or on the heat-resistant layer, the rustproofing layer, the chromate treated layer, or the silane coupling treated layer in accordance with a roll coater method as an example and, if necessary, is dried by heating to remove the solvent to obtain B-stage of the resin. In the drying operation, for example a hot-air drying furnace may be used. The drying temperature may be 100 to 250 °C and preferably 130 to 200 °C.

The carrier-attached copper foil having the resin layer (resin-attached carrier-attached copper foil) is used in the following manner. After the resin layer is laminated on a substrate, the entire construct is subjected to thermocompression to cure the resin layer. The carrier is detached to expose the ultra-thin copper layer (naturally, the surface of the ultra-thin copper layer on the side near the intermediate layer is exposed), and a predetermined wiring pattern is formed thereon.

When the resin-attached carrier-attached copper foil is used, the number of prepreg material used during manufacturing of a multilayer printed wiring board can be reduced. In addition, the thickness of the resin layer is controlled such that interlayer insulation can be ensured and a copper-clad laminate can be produced even if a prepreg material is not used at all. At this time, the surface of the substrate is undercoated with an insulating resin to further improve smoothness of the surface.

Note that the case where a prepreg material is not used is economically advantageous because the cost for a prepreg material can be saved and the laminating step is simplified. In addition, the thickness of the resultant multilayer printed circuit board can be reduced as much as the thickness of the prepreg material. As a result, an ultra-thin multilayer printed wiring board with a thickness of a single layer being 100 μm or less is advantageously produced.

The thickness of the resin layer is preferably 0.1 to 80 μm. When the thickness of the resin layer is lower than 0.1 μm, adhesion strength reduces. When such a resin-attached carrier-attached copper foil is laminated on a substrate having an interlayer material without interposing a prepreg material, it is sometimes difficult to ensure interlayer insulation with the circuit of the interlayer material.

In contrast, when the thickness of the resin layer is greater than 80 μm, it becomes difficult to form a resin layer having a desired thickness in a single coating step and economically disadvantageous because an extra material cost and an extra number of steps are required. Moreover, cracks are readily formed during handling because the thickly formed resin layer is less flexible, and smooth lamination may be difficult because excessive resin flow may be caused at the time of thermocompression with the interlayer material.

Furthermore, another product form of the resin-attached carrier-attached copper foil can also be produced as follows. The ultra-thin copper layer, or the heat-resistant layer, rustproofing layer, or the chromate treated layer, or the silane coupling-treated layer is covered with a resin layer, the resin layer is made in a semi-cured state, and then the carrier is detached to obtain a resin-attached copper foil without a carrier.

Moreover, a printed wiring board is completed by mounting electronic components etc. on the printed wiring board. In the present invention, "printed wiring board" includes such a printed wiring board, a printed circuit board, and a printed substrate that have electronic components etc. mounted.

In addition, an electronic device may be produced by using this printed wiring board, an electronic device may be produced by using such a printed circuit board that has the electronic components etc. mounted, and an electronic

device may be produced by using such a printed substrate that has electronic components etc. mounted. Some examples of manufacturing processes of a printed wiring board by using the carrier-attached copper foil according to the present invention are provided hereinafter. Note that a printed wiring board can be manufactured as well by using the copper foil according to the preset invention as the ultra-thin copper layer of the carrier-attached copper foil.

In an embodiment of the method of manufacturing a printed wiring board according to the present invention, the method of the invention includes a step of preparing a carrier-attached copper foil according to the present invention and an insulating substrate, a step of laminating the carrier-attached copper foil and the insulating substrate, a step of detaching the carrier from the carrier-attached copper foil after the carrier-attached copper foil and the insulating substrate are laminated such that an ultra-thin copper layer faces the insulating substrate to form a copper-clad laminate, and thereafter a step of forming a circuit by any one of a semi-additive method, a modified semi-additive method, a partly additive method and a subtractive method. The insulating substrate may have an inner layer circuit.

In the present invention, the semi-additive method refers to a method of forming a conductor pattern by applying non-electrolytic plating onto an insulating substrate or a copper foil seed layer to form a thin plating layer, forming a pattern, and thereafter applying electroplating and etching.

Accordingly, in the embodiment of the method of manufacturing a printed wiring board according to the present invention using the semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of completely removing an ultra-thin copper layer exposed by detaching the carrier by an etching method using a corrosive solution such as an acid, or a plasma method etc.,
a step of forming through-holes or/and blind vias in the resin exposed by removing the ultra-thin copper layer by etching,
a step of applying a desmear treatment to a region containing the through-holes or/and blind vias,
a step of providing an non-electrolytic plating layer on the region containing the resin, the through-holes or/and blind vias,
a step of forming a plating resist on the non-electrolytic plating layer,
a step of applying light to the plating resist to remove the plating resist of a region in which the circuit is to be formed,
a step of forming an electrolytic plating layer on the region in which the circuit is to be formed and the plating resist has been removed
a step of removing the plating resist, and
a step of removing by flash etching etc. the non-electrolytic plating layer present in the region except the region in which the circuit is to be formed.

In another embodiment of the method of manufacturing a printed wiring board according to the present invention using the semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of forming through-holes or/and blind vias in a ultra-thin copper layer exposed by detaching the carrier and in the insulating resin substrate,
a step of applying a desmear treatment to a region containing the through-holes or/and blind vias,
a step of completely removing an ultra-thin copper layer exposed by detaching the carrier by an etching method using a corrosive solution such as an acid, or a plasma method etc.,
a step of forming a non-electrolytic plating layer on the resin exposed by removing the ultra-thin copper layer by etching and the region containing the through-holes or/and blind vias,
a step of forming a plating resist on the non-electrolytic plating layer,
a step of applying light to the plating resist, and thereafter removing the plating resist of a region in which the circuit is to be formed,
a step of forming an electrolytic plating layer on the region in which the circuit is to be formed and the plating resist has been removed,
a step of removing the plating resist, and
a step of removing by flash etching etc. the non-electrolytic plating layer present in the region except the region in which the circuit is to be formed,.

In another embodiment of the method of manufacturing a printed wiring board according to the present invention using the semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating

substrate are laminated,
a step of forming through-holes or/and blind vias in a ultra-thin copper layer exposed by detaching the carrier and in the insulating resin substrate,
a step of completely removing an ultra-thin copper layer exposed by detaching the carrier by an etching method using a corrosive solution such as an acid, or a plasma method etc.,
a step of applying a desmear treatment to a region containing the through-holes or/and blind vias,
a step of forming a non-electrolytic plating layer on the resin exposed by removing the ultra-thin copper layer by etching and the region containing the through-holes or/and blind vias,
a step of forming a plating resist on the non-electrolytic plating layer,
a step of applying light to the plating resist, and thereafter removing the plating resist of a region in which the circuit is to be formed,
a step of forming an electrolytic plating layer on the region in which the circuit is to be formed and the plating resist has been removed,
a step of removing the plating resist, and
a step of removing by flash etching etc. the non-electrolytic plating layer present in the region except the region in which the circuit is to be formed.

In another embodiment of the method of manufacturing a printed wiring board according to the present invention using the semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of completely removing an ultra-thin copper layer exposed by detaching the carrier by an etching method using a corrosive solution such as an acid, or a plasma method,
a step of forming a non-electrolytic plating layer on the surface of the resin exposed by removing the ultra-thin copper layer by etching,
a step of forming a plating resist on the non-electrolytic plating layer,
a step of applying light to the plating resist, and thereafter removing the plating resist of a region in which the circuit is to be formed,
a step of forming an electrolytic plating layer on the region in which the circuit is to be formed and the plating resist has been removed,
a step of removing the plating resist, and
a step of removing by flash etching etc. the non-electrolytic plating layer and the ultra-thin copper layer present in the region except the region in which the circuit is to be formed.

In the present invention, the modified semi-additive method refers to a method of forming a circuit on an insulating layer by laminating a metal foil on an insulating layer, protecting a non-circuit forming portion with a plating resist, thickening a circuit forming portion with copper by electrolytic plating, removing the resist and removing the metal foil of the region except the circuit forming portion by (flash) etching.

Accordingly, in the embodiment of the method of manufacturing a printed wiring board according to the present invention using the modified semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of forming through-holes or/and blind vias in the ultra-thin copper layer exposed by detaching the carrier and in the insulating substrate,
a step of applying a desmear treatment to a region containing the through-holes or/and blind vias,
a step of providing an non-electrolytic plating layer on the region containing the through-holes or/and blind vias,
a step of forming a plating resist on the surface of the ultra-thin copper layer exposed by detaching the carrier,
a step of forming a circuit by electro plating after the plating resist is formed,
a step of removing the plating resist, and
a step of removing by flash etching the ultra-thin copper layer exposed by removing the plating resist.

In another embodiment of the method of manufacturing a printed wiring board according to the present invention using the modified semi-additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,

a step of forming a plating resist on the ultra-thin copper layer exposed by detaching the carrier,
a step of applying light to the plating resist to remove the plating resist in the region in which a circuit is to be formed,
a step of forming an electrolytic plating layer on the region in which the circuit is to be formed and the plating resist has been removed,
a step of removing the plating resist; and
a step of removing by flash etching etc. the non-electrolytic plating layer and the ultra-thin copper layer in the region except the region in which the circuit is to be formed.

In the present invention, the partly additive method refers to a method of manufacturing a printed-wiring board, which includes providing a catalyst nucleus on a substrate having a conductor layer and, as needed, having holes for through-holes and via holes, forming a conductor circuit by etching, providing a solder resist or a plating resist, as needed, and thickening the conductor circuit, through-hole, via holes, etc. by non-electrolytic plating.

Accordingly, in the embodiment of the method of manufacturing a printed wiring board according to the present invention using the partly additive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of forming through-holes or/and blind vias in the ultra-thin copper layer exposed by detaching the carrier and in the insulating substrate,
a step of applying a desmear treatment to the region containing the through-hole or/and blind vias,
a step of providing a catalyst nucleus to the region containing the through-hole or/and blind vias,
a step of providing an etching resist to the ultra-thin copper layer surface exposed by detaching the carrier,
a step of forming a circuit pattern by applying light to the etching resist,
a step of forming a circuit by removing the ultra-thin copper layer and the catalyst nucleus by an etching method using a corrosive solution such as an acid or a plasma method,
a step of removing the etching resist,
a step of forming a solder resist or a plating resist on the surface of the insulating substrate exposed by removing the ultra-thin copper layer and the catalyst nucleus by an etching method using a corrosive solution such as an acid or a plasma method; and
a step of providing a non-electrolytic plating layer in the region in which neither the solder resist nor plating resist is provided.

In the present invention, the subtractive method refers to a method of forming a conductor pattern by selectively removing an unwanted part in the copper foil on a copper-clad laminate by etching etc.

Accordingly, in the embodiment of the method of manufacturing a printed wiring board according to the present invention using the subtractive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of forming through-holes or/and blind vias in the ultra-thin copper layer exposed by detaching the carrier and in the insulating substrate,
a step of applying a desmear treatment to the region containing the through-hole or/and blind vias,
a step of providing an non-electrolytic plating layer in the region containing the through-hole or/and blind vias,
a step of providing an electrolytic plating layer on the surface of the non-electrolytic plating layer,
a step of providing an etching resist on the surface of the electrolytic plating layer or/and the ultra-thin copper layer,
a step of forming a circuit pattern by applying light to the etching resist,
a step of forming a circuit by removing the ultra-thin copper layer, the non-electrolytic plating layer and the electrolytic plating layer by an etching method using a corrosive solution such as an acid or a plasma method etc., and
a step of removing the etching resist.

In another embodiment of the method of manufacturing a printed wiring board according to the present invention using the subtractive method, the method of the invention includes
a step of preparing a carrier-attached copper foil according to the present invention and an insulating substrate,
a step of laminating the carrier-attached copper foil and the insulating substrate,
a step of detaching the carrier from the carrier-attached copper foil after the carrier-attached copper foil and the insulating substrate are laminated,
a step of forming through-holes or/and blind vias in the ultra-thin copper layer exposed by detaching the carrier and in the insulating substrate,
a step of applying a desmear treatment to the region containing the through-hole or/and blind vias,

a step of providing an non-electrolytic plating layer on the region containing the through-hole or/and blind vias,
a step of forming a mask on the surface of the non-electrolytic plating layer,
a step of forming an electrolytic plating layer on the surface of the non-electrolytic plating layer in which no mask is formed,
a step of forming an etching resist on the surface of the electrolytic plating layer or/and the ultra-thin copper layer,
a step of forming a circuit pattern by applying light to the etching resist,
a step of forming a circuit by removing the ultra-thin copper layer and the non-electrolytic plating layer by an etching method using a corrosive solution such as an acid or a plasma method etc., and
a step of removing the etching resist.

The step of forming through-holes or/and blind vias and the next step of desmear treatment may not be performed.

Here, the method of manufacturing a printed wiring board using the carrier-attached copper foil of the invention will be more specifically described below with reference to figures. Note that although an example of the method of manufacturing using a carrier-attached copper foil that has an ultra-thin copper layer on which a roughened layer is formed is provided hereafter, the method of manufacturing is not limited to this method. The following method of manufacturing a printed wiring board can also be performed in the similar manner by using a carrier-attached copper foil having an ultra-thin copper layer on which a roughened layer is not formed.

First, as shown in Figure 1-A, a carrier-attached copper foil (first layer) having an ultra-thin copper layer having a roughened layer formed on the surface is prepared.

Next, as shown in Figure 1-B, a resist is applied onto the roughened layer on the ultra-thin copper layer and subjected to a light exposure and development operation to etch the resist into a predetermined shape.

Next, as shown in Figure 1-C, plating for a circuit is formed and thereafter the resist is removed to form a circuit plating having a predetermined shape.

Next, as shown in Figure 2-D, an embedding resin is provided on the ultra-thin copper layer so as to cover the circuit plating (so as to bury the circuit plating) and subsequently another carrier-attached copper foil (second layer) is bonded from the side of the ultra-thin copper layer.

Next, as shown in Figure 2-E, the carrier is removed from the carrier-attached copper foil that is the second layer.

Next, as shown in Figure 2-F, holes are formed by applying laser at the predetermined positions of the resin layer and the circuit plating is exposed to light to form blind vias.

Next, as shown in Figure 3-G, blind vias are embedded with copper to form via fill.

Next, as shown in Figure 3-H, circuit plating is formed on the via fill, as Figure 1-B and Figure 1-C described above.

Next, as shown in Figure 3-1, the carrier is removed from the carrier-attached copper foil that is the first layer.

Next, as shown in Figure 4-J, the ultra-thin copper layer of both surfaces are removed by flash etching to expose the surface of the circuit plating within the resin layer.

Next, as shown in Figure 4-K, bumps are formed on the circuit plating within the resin layer and a copper pillar is formed on the solder. In this manner, a printed-wiring board using the carrier-attached copper foil of the invention is prepared.

Note that in the above descriptions of the method of manufacturing a printed wiring board, it is also possible to replace "ultra-thin copper layer" with "carrier" and to replace "carrier" with "ultra-thin copper layer". In this manner, manufacture of a printed wiring board can be performed by forming a circuit on the surface of the carrier-attached copper foil on the carrier side and embedding the circuit in the resin.

As the above another carrier-attached copper foil (second layer), the carrier-attached copper foil of the present invention, a conventional carrier-attached copper foil or a general copper foil may be used. On the circuit on the second layer shown in Figure 3-H, an additional layer of circuit or additional layers of circuits may be formed. These circuits may be formed by any one of a semi-additive method, a subtractive method, a partly additive step and a modified semi-additive method.

According to the method of manufacturing the printed wiring board as described above, the circuit plating is configured to be embedded in the resin layer. Thus, when removing the ultra-thin copper layer by flash etching as illustrated in Figure 4-J, for example, the circuit plating is protected by the resin layer, maintaining its geometry, thereby making it easy to form a microcircuit. Also, since the circuit plating is protected by the resin layer, migration resistance improves, and the electric connection between circuit wirings can be favorably suppressed. Thus, it becomes easy to form a microcircuit. As illustrated in Figures 4-J and 4-K, when the ultra-thin copper layer has been removed by flash etching, the exposed surface of the circuit plating is recessed within the resin layer. Thus, it becomes easy to form bumps on the circuit plating and copper pillars over the bumps, increasing the manufacturing efficiency.

Note that as the embedding resin (resin), a resin known in the art and a prepreg can be used. For example, BT (bismaleimide triazine) resin and a prepreg, which is glass cloth impregnated with a BT resin, ABF film and ABF manufactured by Ajinomoto Fine-Techno Co., Inc. can be used. As the embedding resin (resin), the resin layer and/or resin and/or prepreg described in the specification can be used.

Furthermore, the carrier-attached copper foil used as the first layer may have a substrate and a resin layer on

a surface of the carrier-attached copper foil. The presence of the substrate or resin layer is advantageous since the carrier-attached copper foil used as the first layer is supported and wrinkle is not readily formed, and therefore productivity is improved. Note that as the substrate or the resin layer, any substrate may be used as long as it has an effect of supporting the carrier-attached copper foil used as the first layer. Example of the substrate or the resin layer that can be used herein include a carrier, a prepreg and a resin layer as described in the specification; a carrier, a prepreg, a resin layer, a metal plate, a metal foil, a plate of an inorganic compound, a foil of an inorganic compound, a board of an organic compound and a foil of an organic compound known in the art.

In addition, the method of manufacturing a printed wiring board according to the present invention may be one of methods of manufacturing a printed wiring board (coreless technique) that includes a step of laminating the carrier-attached copper foil on a resin substrate so as to attach a surface on a side of the ultra-thin copper layer or a surface on a side of the carrier side of the carrier to the resin substrate, a step of providing two layers including a resin layer and a circuit at least once on a surface of the carrier-attached copper foil that is on the opposite side of the surface to which the resin substrate is laminated, and a step of detaching the carrier or the ultra-thin copper layer from the carrier-attached copper foil after forming the two layers including a resin layer and a circuit. Note that the two layers including a resin layer and a circuit may be provided in the order of a resin layer and a circuit or in the order of a circuit and a resin layer. A specific example of this coreless technique is such that a laminate (also referred to as a copper-clad laminate board or a copper-clad laminate) is manufactured, first, by attaching a resin substrate to a surface on the ultra-thin copper layer side or a surface on the carrier side of a carrier attached copper foil to laminate. Afterwards, a resin layer is formed on the surface of the carrier-attached copper foil that is on the opposite side of the surface to which the resin substrate is attached. A surface on an ultra-thin copper layer side or a surface on a carrier side of another carrier-attached copper foil may be further attached to the resin layer that is formed on the surface on the ultra-thin copper layer side or a surface on the carrier side to laminate the resin layer and another carrier-attached copper foil. In addition, the above-described method of manufacturing a printed wiring board (coreless technique) may use a laminate having a configuration in which a resin substrate, a resin, or a prepreg is placed at the center of the laminate, and on both surfaces of the resin substrate, the resin, or the prepreg, carrier-attached copper foils are layered in the order of a carrier/an intermediate layer/an ultra-thin copper layer or in the order of an ultra-thin copper layer/an intermediate layer/a carrier. Another layer or other layers may be placed between the resin substrate, the resin, or the prepreg and one or both carrier-attached copper foils. Alternatively, a laminate having a configuration in which "a carrier/an intermediate layer/an ultra-thin copper layer/a resin substrate, a resin, or a prepreg/a carrier/an intermediate layer/an ultra-thin copper layer", a laminate having a configuration in which "a carrier/an intermediate layer/an ultra-thin copper layer/a resin substrate/a carrier/an intermediate layer/an ultra-thin copper layer", or a laminate having a configuration in which "an ultra-thin copper layer /an intermediate layer/a carrier/a resin substrate /a carrier/an intermediate layer/an ultra-thin copper layer" may be used in the method of manufacturing a printed wiring board (coreless technique) described above.

Another resin layer may be provided on the exposed surface of the ultra-thin copper layer or the carrier that is the outermost layer of the laminate, and a copper layer or a metal layer may be further deposited over the resin layer so that a circuit or a wiring is formed by processing the copper layer or the metal layer. Furthermore, another resin layer may be provided on the circuit or the wiring so as to embed (bury) the circuit or the wiring in the resin layer. Alternatively, a copper or metal circuit or a copper or metal wiring may be provided on the exposed surface of the ultra-thin copper layer or the carrier that is the outermost layer of the laminate, and another resin layer may be provided on the wiring or the circuit so that the wiring or the circuit is embedded (buried) in the resin layer. Over this resin layer, a circuit or a wiring and a resin layer may be formed afterwards. This formation of a circuit or a wiring and a resin layer may be performed once or more than once (buildup technique). In the laminate formed in this manner (hereinafter also referred to as laminate B), the ultra-thin copper layer or the carrier of each carrier-attached copper foil can be detached from the carrier or the ultra-thin copper layer, respectively, so as to produce a coreless substrate. Note that in the above-described production of a coreless substrate, any of a laminate having a configuration of an ultra-thin copper layer/an intermediate layer/a carrier/a carrier/an intermediate layer/an ultra-thin copper layer, a laminate having a configuration of a carrier/an intermediate layer/an ultra-thin copper layer/an ultra-thin copper layer/an intermediate layer/a carrier, and a laminate having a configuration of a carrier/an intermediate layer/an ultra-thin copper layer/a carrier/an intermediate layer/an ultra-thin copper layer that are described later is produced by using two carrier-attached copper foils, and the produced laminate may be placed at the center. On the surfaces of the ultra-thin copper layer or the carrier arranged in the outermost layer of any of these laminates (hereinafter also referred to as laminate A), two layers including a resin layer and a circuit are provided once or more than once, and after providing the two layers once or more than once, a coreless substrate may be produced by detaching the ultra-thin copper layer or the carrier of each carrier-attached copper foil from the carrier or the ultra-thin copper layer, respectively. Note that the two layers including a resin layer and a circuit may be deposited in the order of a resin layer and a circuit or in the order of a circuit and a resin layer. The above-described laminates may have another layer or other layers on the surface of the ultra-thin copper layer, on the surface of the carrier, between the carriers, between the ultra-thin copper layers, and between the carrier and the ultra-thin copper layer. Such another layer or other layers may be a resin substrate or a resin layer. Note that in this specification,

when an ultra-thin copper layer, a carrier, or a laminate has another layer or other layers on its surface, "surface of an/the ultra-thin copper layer", "surface on an/the ultra-thin copper layer side", "an/the ultra-thin copper layer surface", "surface of a/the carrier", "surface on a/the carrier side", "a/the carrier surface", "surface of a/the laminate", and "a/the laminate surface" refer to the outermost surface of the ultra-thin copper layer, the carrier, or the laminate, or in other words, the concept of these terms includes the surface of such another layer or other layers. The laminate preferably has a configuration of an ultra-thin copper layer/an intermediate layer/a carrier/a carrier/an intermediate layer/an ultra-thin copper layer. This is because at the time of producing a coreless substrate by using such a laminate, an ultra-thin copper layer is arranged on the coreless substrate side and a circuit can be readily formed on the coreless substrate by using the modified semi-additive method. Another reason is that because an ultra-thin copper layer is thin, the ultra-thin copper layer can be readily removed and a circuit can be readily formed on the coreless substrate by using the semi-additive method after the removal of the ultra-thin copper layer.

Note that in this specification, "laminate" that is not specifically written as "laminate A" or "laminate B" refers to a laminate that includes at least laminate A and laminate B.

Note that in the above-described method of manufacturing a coreless substrate, by covering a portion or all of edge face(s) of the carrier-attached copper foil or the above-described laminate (including laminate A) with a resin, penetration of chemical into the intermediate layer or between carrier-attached copper foils that configure the laminate can be prevented at the time of manufacturing a printed wiring board by using the buildup technique. As a result, separation between an ultra-thin copper layer and a carrier and corrosion of carrier-attached copper foils that are caused by the penetration of chemical can be prevented and consequently yield can be improved. "A resin to cover a portion or all of edge face(s) of the carrier-attached copper foil" or "a resin to cover a portion or all of edge face(s) of the laminate" used herein can be a resin that can be used for the resin layer or a resin known in the art. In the above-described method of manufacturing a coreless substrate, at least a portion of outer edge of the laminated portion of the carrier-attached copper foil or the laminate (a laminated portion of the carrier and the ultra-thin copper layer, the laminated portion possibly including the intermediate layer and/or one or more layers, or a laminated portion of one carrier-attached copper foil and another carrier-attached copper foil, the laminated portion possibly including one or more layers) as viewed planarly may be covered with a resin or a prepreg. The laminate (laminate A) formed by the above-described method of manufacturing a coreless substrate may be configured by bringing a pair of carrier-attached copper foils into contact with each other in such a manner that the carrier-attached copper foils can be separated. Moreover, all of outer edge or allover the laminated portion of the carrier-attached copper foil or the laminate (a laminated portion of the carrier and the ultra-thin copper layer, the laminated portion possibly including the intermediate layer and/or one or more layers, or a laminated portion of one carrier-attached copper foil and another carrier-attached copper foil, the laminated portion possibly including one or more layers) as viewed planarly may be covered with a resin or a prepreg. The resin or the prepreg as viewed planarly is preferably larger than the carrier-attached copper foil, the laminate, or the laminated portion, and the resultant carrier-attached copper foil or the laminate preferably has a structure in which the resin or the prepreg is deposited on both surfaces of the carrier-attached copper foil or the laminate and the carrier-attached copper foil or the laminate is wrapped (enveloped) by the resin or the prepreg. In such a structure, when the carrier-attached copper foil or the laminate is viewed planary, because an outer edge or edges of the laminated portion of the carrier-attached copper foil or the laminate are covered with the resin or the prepreg, it is possible to prevent another component or other components from directly contacting the carrier-attached copper foil or the laminate from a side direction, i.e., a lateral direction with respect to the direction of lamination, and as a result, the carrier becomes less likely to be detached from the ultra-thin copper layer or the carrier-attached copper foils become less likely to be detached from one another during handling. In addition, by covering the outer edges of the laminated layers of the carrier-attached copper foil or the laminate with a resin or a prepreg so as not to expose the carrier-attached copper foil or the laminate, as described above, penetration of chemical into an interface of the laminated layers can be prevented in a process of chemical treatment, and therefore corruption and erosion of the carrier-attached copper foil can be prevented. Note that at the time of separating one of a pair of carrier-attached copper foils in a laminate from another or separating a carrier from a copper foil (ultra-thin copper layer) in a carrier-attached copper foil, when a laminated portion of a carrier-attached copper foil or a laminate (a laminated portion of the carrier and the ultra-thin copper layer, the laminated portion possibly including the intermediate layer and/or one or more layers, or a laminated portion of one carrier-attached copper foil and another carrier-attached copper foil, the laminated portion possibly including one or more layers) that is covered with a resin or a prepreg are strongly adhered to each other by the resin or the prepreg, the adhered portion of the laminated portion may need to be removed by cutting the portion off etc.

It is also possible to configure a laminate by depositing a carrier-attached copper foil of the present invention from its carrier side or its ultra-thin copper layer side on a carrier side or an ultra-thin copper layer side of another carrier-attached copper foil. Alternatively, the laminate may be obtained by directly bonding a carrier side surface or an ultra-thin copper layer side surface of one carrier-attached copper foil of the present invention to a carrier side surface or an ultra-thin copper layer side surface of another carrier-attached copper foil via an adhesive when needed. The carrier or the ultra-thin copper layer of such a carrier-attached copper foil may be joined to the carrier or the ultra-thin copper layer

of such another carrier-attached copper foil. Here, "joining" includes a mode in which, when a carrier or an ultra-thin copper layer has a surface treatment layer, the carrier or the ultra-thin copper layer is joined via the surface treatment layer. In addition, a portion or all of edge face(s) of such a laminate may be covered with a resin.

In addition to merely depositing layers, the following methods can be used for example for lamination of carriers, lamination of ultra-thin copper layers, lamination of a carrier and an ultra-thin copper layer, and lamination of carrier-attached copper foils.

(a) Metallurgical joining methods: fusion welding (arc welding, TIG (Tungsten Inert Gas) welding, MIG (Metal Inert Gas) welding, resistance welding, seam welding, spot welding), pressure welding (ultrasonic welding, friction stir welding), brazing and soldering;
(b) Mechanical joining methods: joining by swaging, riveting(joining by self-piercing rivets, riveting), stitcher;
(c) physical joining methods: adhesive, (two-sided) adhesive tape.

By joining a portion of or all of one carrier to a portion of or all of another carrier or a portion of or all of an ultra-thin copper layer by using any of the above joining methods, one carrier can be layered onto another carrier or an ultra-thin copper layer, and it is therefore possible to manufacture a laminate configured by bringing the carriers or the carrier and the ultra-thin copper layer into separable contact with each other. When one carrier and another carrier or an ultra-thin copper layer are laminated by weak joining of the carriers or the carrier and the ultra-thin copper layer, the carriers or the carrier and the ultra-thin copper layer can be separated from each other without removing the joining of the carriers or the carrier and the ultra-thin copper layer. When one carrier and another carrier or an ultra-thin copper layer are strongly joined together, the carriers or the carrier and the ultra-thin copper layer can be separated from each other by removing a site where the carriers or the carrier and the ultra-thin copper layer are joined by cutting the site off, chemical milling (etching etc.), and mechanical milling and other techniques.

A printed wiring board that does not have a core may be produced by performing a step of providing two layers including a resin layer and a circuit at least once on the laminate described above, and a step of detaching the carrier or the ultra-thin copper layer from the carrier-attached copper foil after forming the two layers including a resin layer and a circuit. Note that the two layers including a resin layer and a circuit may be provided on one surface or each of both surfaces of the laminate. Note that the two layers including a resin layer and a circuit may be provided in the order of a resin layer and a circuit or in the order of a circuit and a resin layer.

A resin substrate, a resin layer, a resin, a prepreg used in the laminate described above may be the resin layer described in this specification and may contain any of the resin, the resin curing agent, the compound, the curing accelerator, the dielectric substance, the reaction catalyst, the crosslinking agent, the polymer, the prepreg, the skeletal material, and others that are used for the resin layer described in this specification.

Note that the above-described carrier-attached copper foil or laminate may be smaller than the resin, the prepreg, the resin substrate or the resin layer as viewed planarly.

Moreover, the resin substrate is not specifically limited as long as the resin substrate has characteristics that are applicable to a printed wiring board etc., but for such a resin substrate, a paper based phenol resin, a paper based epoxy resin, a synthetic fiber cloth-based epoxy resin, a glass cloth/paper composite based epoxy resin, a glass cloth/non-woven glass cloth composite based epoxy resin and a glass cloth based epoxy resin, etc. can be used for a rigid PWB, and a polyester film, a polyimide film, a liquid crystal polymer (LCP) film, a fluororesin, a low dielectric polyimide resin film, and a cyclo-olefin polymer (COP) resin film etc. can be used for FPC. Note that when a liquid crystal polymer (LCP) film or a fluororesin is used, the peel strength between the film and a surface-treated copper foil becomes smaller than the peel strength between a polyimide film and the surface-treated copper foil. For that reason, when a liquid crystal polymer (LCP) film or a fluororesin is used, after a copper circuit is formed, the copper circuit is covered with a coverlay so that the film and a copper circuit do not easily detach from each other. Therefore detachment of the film from the copper circuit due to the smaller peel strength can be prevented.

It should be noted that because the dielectric tangent (DF) is small in a liquid crystal polymer (LCP) film, a fluororesin film, a low dielectric polyimide resin film, and a cyclo-olefin polymer (COP) resin film, the copper-clad laminate, the printed wiring board, or the printed circuit board that uses a liquid crystal polymer (LCP) film, a fluororesin film, a low dielectric polyimide resin film, or a cyclo-olefin polymer (COP) resin film and the surface-treated copper foil according to the present invention is suitable for use in a high-frequency circuit (a circuit that transmits signals at high frequencies). In addition, because the surface-treated copper foil according to the present invention has a small surface roughness Rz and a high glossiness, the surface is smooth and is suitable for use in a high-frequency circuit. Note that polyimide resins of which the value of the dielectric tangent (DF) is 0.01 or less is defined as low dielectric polyimide resins in the present specification. The dielectric tangent (DF) can be measured by the triplate-line resonator method described in "A test method for copper-clad laminates for printed wiring boards dielectric constant and dissipation factor" JPCA-TM001-2007 published by Japan Electronics Packaging and Circuits Association. The copper-clad laminate may be formed by attaching the copper foil and the insulating substrate via an adhesive. Any adhesive known in the art can be

used for the above-described adhesive. For the above-describe adhesive, the use of a low dielectric adhesive is preferable. In the present specification, an adhesive of which the dielectric constant is 3.5 or less is regarded as a low dielectric adhesive. Note that, in the present specification, the values of the dielectric constant (the base material dielectric constant, the substrate dielectric constant, the dielectric constant of resin) and the dielectric tangent (the base material dielectric tangent, the substrate dielectric tangent, the dielectric tangent of resin) refer to the values of the dielectric constant and the dielectric tangent when the signal frequency is 1 GHz.

In addition, the copper foil or the carrier-attached copper foil according to the present invention can be suitably used as battery material such as a negative current collector of a secondary battery such as a lithium-ion secondary battery. Because the average particle size of the roughening particles and Ra after a surface treatment such as the roughening treatment are controlled to be kept within a prescribed range in the copper foil or the carrier-attached copper foil according to the present invention, compared with the copper foil or the carrier-attached copper foil that is not controlled, the following advantages are found in the copper foil or the carrier-attached copper foil according to the present invention. The copper foil or the carrier-attached copper foil according to the present invention has a good adhesive property with active materials. When an active material is provided on the surface of the copper foil or the carrier-attached copper foil, variation in the deposition amount of the active material can be reduced. As another example, when the copper foil or the carrier-attached copper foil according to the present invention is used as a current collector of a battery or a secondary battery and an active material thin film is formed over the copper foil or the carrier-attached copper foil, an electrode can be manufactured. Ultimately, a battery or a secondary battery with the above-described electrode (either a positive electrode or a negative electrode) can be manufactured. A method of forming an active material thin film over a current collector is not particularly limited, but the method includes the CVD technique, the sputtering technique, the vapor deposition technique, the spraying technique, a method of applying a solution containing the active material over a current collector and drying the solution, or a plating technique. From among these techniques and methods of thin film formation, the CVD technique, the sputtering technique, and the vapor deposition technique are particularly preferred. In addition, an intermediate layer may be formed over the current collector and an active material thin film may be formed over the intermediate layer. The copper foil or the carrier-attached copper foil according to the present invention can be used in any electrodes known in the art, any current collectors known in the art, and any batteries known in the art. The batteries known in the art include a lithium-ion secondary battery, an all-solid secondary battery, an air battery (such as a lithium-air battery, a zinc-air battery), a sodium ion battery, a magnesium ion battery, a multivalent ion battery, a secondary battery using a sulfuric substance as the positive electrode, a secondary battery using a redox-active organic compound as the positive electrode, a nickel-cadmium battery, a manganese battery (a dry-cell battery), an alkaline battery (a dry-cell battery), and a lithium battery (a dry-cell batter), etc. The electrodes known in the art and the current collectors known in the art include the electrodes and the current collectors used in the above-described batteries known in the art.

[Example]

In the following descriptions, explanations are provided on the basis of Examples and Comparative Examples. Note that Examples in the present specification are mere examples, and the present invention is not limited to the examples. In other words, other modes or modifications of the present invention are also included.

The untreated foil used in Examples 1, 3, 4, and 6-41 and Comparative Examples 1, 2, and 4-6 described below was a 9-18 μm thick standard rolled copper foil TPC (a tough pitch copper that meets JIS H3100 C1100, manufactured by JX Nippon Mining & Metals Corporation).

The original foil used in Examples 2 and 5 and Comparative Example 3 was a carrier-attached copper foil manufactured by employing the following method.

In Example 5 and Comparative Example 3, an 18-μm thick electrolytic copper foil (JTC foil manufactured by JX Nippon Mining & Metals Corporation) was prepared as a carrier, and in Example 2, an 18 μm thick standard rolled copper foil TPC was prepared as a carrier. Under the following conditions, an intermediate layer was formed on a surface of the carrier, and an ultra-thin copper layer was formed on a surface of the intermediate layer. Note that when the carrier was an electrolytic copper foil, the intermediate layer was formed on a shiny face (S face).

It should be noted that "standard" in the above "standard rolled copper foil TPC" means that the rolled copper foil TPC has the composition of tough-pitch copper that complies with the standard provided in JIS H3100 C1100. Note that the arithmetic mean roughness Ra and the ten point mean roughness Rz of the surface of the copper foil or the surface of the ultra-thin copper layer before surface treatment such as roughening treatment were controlled as below. The arithmetic mean roughness Ra and the ten point mean roughness Rz of the surface of the copper foil or the surface of the ultra-thin copper layer before surface treatment such as roughening treatment were provided in Tables 1 to 3.

When a rolled copper foil is used, the arithmetic mean roughness Ra of the surface of mill rolls used in the final cold rolling was set to be 0.14 μm or less. By reducing the arithmetic mean roughness Ra of the surface of mill rolls used in the final cold rolling, the arithmetic mean roughness Ra of the copper foil surface before a surface treatment

such as a roughening treatment can be made smaller. By increasing the arithmetic mean roughness Ra of the surface of mill rolls used in the final cold rolling, the arithmetic mean roughness Ra of the copper foil surface before a surface treatment such as a roughening treatment can be made larger. The oil film equivalent amount at the time of the final cold rolling was set to be 12000-26000. By reducing the oil film equivalent amount at the time of the final cold rolling, the arithmetic mean roughness Ra and/or the ten point mean roughness Rz of the copper foil surface before a surface treatment such as a roughening treatment can be made smaller. By increasing the oil film equivalent amount at the time of the final cold rolling, the arithmetic mean roughness Ra and/or the ten point mean roughness Rz of the copper foil surface before a surface treatment such as a roughening treatment can be made larger.

The oil film equivalent amount is expressed by the following equation.

$$(\text{oil film equivalent amount}) = \{(\text{viscosity of rolling oil [cSt]}) \times (\text{rolling speed [mpm]} + \text{rolling peripheral velocity [mpm]})\} / \{(\text{bite angle of roll [rad]}) \times (\text{yield stress of material [kg/mm}^2\text{]})\}$$

The viscosity of rolling oil [cSt] is the kinetic viscosity at 40 °C.

It should be noted that when an electrolytic copper foil is used, by reducing the arithmetic mean roughness Ra and/or the ten point mean roughness Rz of the surface of the cathode drum (electrolytic drum) used at the time of manufacturing the electrolytic copper foil, the arithmetic mean roughness Ra and/or the ten point mean roughness Rz of a shiny face (S face) of the electrolytic copper foil can be made smaller. By increasing the arithmetic mean roughness Ra and/or the ten point mean roughness Rz of the surface of the cathode drum (electrolytic drum) used at the time of manufacturing the electrolytic copper foil, the arithmetic mean roughness Ra and/or the ten point mean roughness Rz of the shiny face of the electrolytic copper foil can be made larger. In addition, by adding a gloss agent or a leveling agent and/or chloride ion to the electrolyte used at the time of manufacturing the electrolytic copper foil, the arithmetic mean roughness Ra and/or the ten point mean roughness Rz of the deposited face (matt face or M face) and/or the shiny face (S face) of the electrolytic copper foil can be made smaller. For the gloss agent and the leveling agent, gloss agents and leveling agents known in the art, or the leveling agent described later can be used.

For an ultra-thin copper layer of the carrier-attached copper foil, by controlling Ra and Rz of the surface of the copper foil used as a carrier by the above-described methods, Ra and Rz of the ultra-thin copper layer surface were controlled. Ra and Rz of the ultra-thin copper layer surface were controlled by adding a leveling agent and chloride ion described later to the electrolyte used at the time of forming the ultra-thin copper layer.

- Example 2

<Intermediate layer>

(1) Ni-Mo layer (nickel-molybdenum alloy plating)

The carrier was electroplated on a roll-to-roll continuous plating line under the following conditions to form a Ni-Mo layer with the deposition amount being 3000 $\mu$g/dm$^2$. Details of the plating conditions are provided below.
(Composition of solution) Nickel(II) Sulfate Hexahydrate: 50 g/dm$^2$, Sodium molybdate dehydrate: 60 g/dm$^2$, sodium citrate: 90 g/dm$^2$
(Solution temperature) 30 °C
(Current density) 1-4 A/dm$^2$
(Plating (current-carrying) time) 3-25 seconds

<Ultra-thin copper layer>

After the surface of the Ni-Mo layer formed in (1) was washed with water and pickled, the electroplating was continued on a roll-to-roll continuous plating line under the following conditions to form a 2-$\mu$m thick ultra-thin copper layer on the Ni-Mo layer, and consequently, a carrier-attached copper foil was manufactured.
Copper concentration: 90-110 g/L
Sulfuric acid concentration: 90-100 g/L
Chloride ion concentration: 50-90 ppm
Leveling agent 1 (bis(3-sulfopropyl)-disulfide): 10-30 ppm
Leveling agent 2 (amine compound): 10-30 ppm

Note that the following amine compound was used as the leveling agent 2.

[Formula 2]

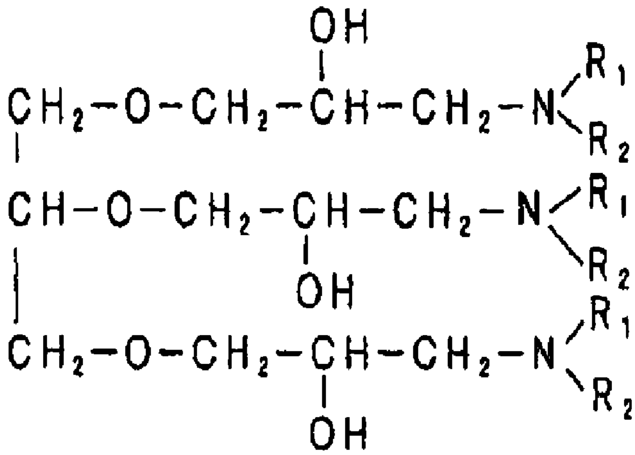

(In the above formula, each of $R_1$ and $R_2$ is selected from a group of a hydroxyalkyl group, an ether group, an aryl group, an aromatic-substituted alkyl group, an unsaturated hydrocarbon group, and an alkyl group.)
Temperature of electrolyte: 50-80 °C
Current density: 100 A/$dm^2$
Electrolyte linear flow rate: 1.5-5 m/sec.

- Example 5

<Intermediate layer>

(1) Ni layer (Ni plating)

The carrier was electroplated on a roll-to-roll continuous plating line under the following conditions to form a Ni layer with the deposition amount being 1000 $\mu$g/$dm^2$. Details of the plating conditions are provided below.
(Composition of solution) Nickel sulfate: 270-280 g/L, Nickel chloride: 35-45 g/L, Nickel acetate: 10-20 g/L, Boric acid: 30-40 g/L, Gloss agent: Saccharine, butynediol or others, Dodecyl sodium sulfate: 55-75 ppm
(pH) 4-6
(Solution temperature) 50-65 °C
(Current density) 10 A/$dm^2$

(2) Organic compound layer (organic compound layer forming process)

Next, after the surface of the Ni layer formed in (1) was washed with water and pickled, a solution containing carboxy-benzotriazole (CBTA) was sprayed on the surface of the Ni layer under the following conditions. The concentration of the solution was 1-30 g/L, the solution was sprayed by showering for 20-120 seconds at the solution temperature 40 °C and pH 5, and consequently, an organic compound layer was manufactured.

<Ultra-thin copper layer>

An ultra-thin copper layer as formed on the organic compound layer formed in (2). The ultra-thin copper layer was formed under the same conditions as Example 2 except that the thickness of the ultra-thin copper layer was 3 $\mu$m.

- Example 3

<Intermediate layer>

(1) Co-Mo layer (cobalt-molybdenum alloy plating)

The carrier was electroplated on a roll-to-roll continuous plating line under the following conditions to form a Co-Mo layer with the deposition amount being 4000 μg/$dm^2$. Details of the plating conditions are provided below.
(Composition of solution) cobalt sulfate: 50 g/$dm^3$, sodium molybdate dehydrate: 60 g/$dm^3$, sodium citrate: 90 g/$dm^3$
(Solution temperature) 30 °C
(Current density) 1-4 A/$dm^2$
(Plating (current-applying) time) 3-25 seconds

<Ultra-thin copper layer>

An ultra-thin copper layer was formed on the Co-Mo layer formed in (1). The ultra-thin copper layer was formed under the same conditions as Example 2 except that the thickness of the ultra-thin copper layer was 5 μm.

(Examples 1-41)

The primary particle layer and the secondary particle layer were formed on a rolled copper foil (Examples 1, 3, 4, 6-41) or the surface of the ultra-thin copper layer of the carrier-attached copper foil (Examples 2 and 5) under the following range of conditions. Details of the conditions were provided in Tables 1 to 3.
The composition of bath that was used and the plating conditions are provided below.

[Composition of bath and plating conditions]

(A) Primary particle layer formation

The primary particle layer was formed on the surface of the copper foil by forming a plated layer under the conditions of primary particle layer formation 1 (A-1) and afterwards by forming a plated layer under the conditions of primary particle layer formation 2 (A-2). The process of primary particle layer formation 1 (A-1) is a process corresponding to roughening plating (rough plating). The process of primary particle layer formation 2 (A-2) is a process corresponding to smooth plating (normal plating).

( A-1) Primary particle layer formation 1 (Cu plating or Cu-W alloy plating)

Detailed conditions were provided in the field of "PRIMARY PARTICLE LAYER FORMING CONDITION (1)" in Table 1.

(Examples 1-27, 29-41: Cu plating)

Composition of solution: copper 13 g/L, sulfuric acid 70 g/L Solution temperature: 36 °C
Current density: 20-58 A/$dm^2$
Quantity of coulomb: 30-80 As/$dm^2$
(Example 28: Cu-W alloy plating)
Composition of solution: copper 13 g/L, tungsten 10 mg/L, sulfuric acid 70 g/L
Solution temperature: 36 °C
Current density: 51 A/$dm^2$
Quantity of coulomb: 67 As/$dm^2$

(A-2) Primary particle layer formation 2 (Examples 1-41: Cu plating)

Detailed conditions were provided in the field of "PRIMARY PARTICLE LAYER FORMING CONDITION (2)" in Table 2. Composition of solution: copper 25 g/L, sulfuric acid 85 g/L Solution temperature: 42 °C
Current density: 6-8 A/$dm^2$

Quantity of coulomb: 12-16 As/$dm^2$

(B) Secondary particle layer formation

In Examples 1-5, 7-11, 13, 15-31, 33-41, the secondary particle layer was formed under the following conditions after forming the primary particle layer as described above.

(Examples 1-5, 7-11, 13, 15-25, 28-31, 33-36: Cu-Co-Ni alloy plating)

Composition of solution: copper 13-16 g/L, nickel 7-9 g/L, cobalt 7-9 g/L
pH: 3
Solution temperature: 37 °C
Current density: 31-45 A/$dm^2$
Quantity of coulomb: 7.2-73.4 As/$dm^2$
(Example 26: Cu-Co alloy plating)
Composition of solution: copper 13 g/L, cobalt 10 g/L pH: 3
Solution temperature: 37 °C
Current density: 32 A/$dm^2$
Quantity of coulomb: 23.9 As/$dm^2$
(Example 27: Cu-Ni alloy plating)
Composition of solution: copper 13 g/L, nickel 10 g/L pH: 3
Solution temperature: 37 °C
Current density: 32 A/$dm^2$
Quantity of coulomb: 11.4 As/$dm^2$
(Example 37: Cu-Ni-P alloy plating)
Composition of solution: copper 13 g/L, nickel 9 g/L, phosphorous 1 g/L
pH: 3
Solution temperature: 37 °C
Current density: 32 A/$dm^2$
Quantity of coulomb: 10.6 As/$dm^2$
(Example 38: Cu-Ni-Mo-W alloy plating)
Composition of solution: copper 13 g/L, nickel 9 g/L, molybdenum 2 g/L, tungsten 3 mg/L
pH: 3
Solution temperature: 37 °C
Current density: 32 A/$dm^2$
Quantity of coulomb: 9.4 As/$dm^2$
(Example 39: Cu-Ni-Fe-Zn alloy plating)
Composition of solution: copper 13 g/L, nickel 9 g/L, iron 1 g/L, zinc 1 g/L
pH: 3
Solution temperature: 37 °C
Current density: 32 A/$dm^2$
Quantity of coulomb: 9.8 As/$dm^2$
(Example 40: Cu-Co-Cr-Ti alloy plating)
Composition of solution: copper 13 g/L, cobalt 9 g/L, chromium 1 g/L, titanium 1 g/L
pH: 3
Solution temperature: 37 °C
Current density: 32 A/$dm^2$
Quantity of coulomb: 23.2 As/$dm^2$
(Example 41: Cu-Co-As alloy plating)
Composition of solution: copper 13 g/L, cobalt 9 g/L, arsenic 0.1 g/L
pH: 3
Solution temperature: 37 °C
Current density: 32 A/$dm^2$
Quantity of coulomb: 22.7 As/$dm^2$

(Comparative Examples 1-6)

In Comparative Examples 1-6, the composition of bath that was used and the plating conditions are provided below.

[Composition of bath and plating conditions]

(A) Primary particle layer formation (copper plating)

(A-1) Primary particle layer formation1 (Cu plating)

Detailed conditions were provided in the field of "PRIMARY PARTICLE LAYER FORMING CONDITION (1)" in Table 1. Composition of solution: copper 13-15 g/L, sulfuric acid 70-75 g/L
Solution temperature: 35-36 °C
Current density: 20-58 A/dm$^2$
Quantity of coulomb: 28.7-92.5 As/dm$^2$

(A-2) Primary particle layer formation 2

Detailed conditions were provided in the field of "PRIMARY PARTICLE LAYER FORMING CONDITION (2)" in Table 2.
Composition of solution: copper 15-25 g/L, sulfuric acid 75-85 g/L
Solution temperature: 35-42 °C
Current density: 1-8 A/dm$^2$
Quantity of coulomb: 4-18 As/dm$^2$

(B) Secondary particle layer formation (Cu-Co-Ni alloy plating)

In Comparative Examples 1, 3-6, the secondary particle layer was formed under the following conditions after forming the primary particle layer as described above.
Composition of solution: copper 13-15 g/L, nickel 8-9 g/L, cobalt 8-9 g/L
pH: 2-3
Solution temperature: 37-40 °C
Current density: 24-32 A/dm$^2$
Quantity of coulomb: 19.8-68.8 As/dm$^2$

It should be noted that in Examples 29, 31, and 32, after forming the roughened layer (primary particle layer, or primary particle layer and secondary particle layer) provided in Tables 1 to 3, a heat-resistant layer, a rustproofing layer, a chromate treated layer, or a silane coupling-treated layer was formed by the following processes. Note that in Example 32, the roughened layer formation in Tables 1 to 3 and the following processes to form a heat-resistant layer, a rustproofing layer, a chromate treated layer, and a silane coupling-treated layer were performed on both faces of the copper foil. The same result was obtained from both of two faces of the copper foil in Example 32.

- Heat-resistant layer formation process

Example 29: Ni plating
Composition of solution: nickel 10-40 g/L
pH: 1.0-5.0
Solution temperature: 30-70 °C
Current density: 1-9 A/dm$^2$
Plating (current-applying) time: 0.1-3 seconds
Example 31: Ni-Co plating
Composition of solution: cobalt 1-20 g/L, nickel 1-20 g/L pH: 1.5-3.5
Solution temperature: 30-80 °C
Current density: 1-20 A/dm$^2$
Plating (current-applying) time: 0.5-4 seconds
Example 32: Co plating

Composition of solution: cobalt 10-40 g/L
pH: 1.0-5.0
Solution temperature: 30-70 °C
Current density: 1-9 A/dm$^2$
Plating (current-applying) time: 0.1-3 seconds

- Rustproofing layer formation process

Example 29: not performed
Example 31: Zn-Ni plating
Composition of solution: zinc 10-30 g/L, nickel 1-10 g/L pH: 3-4
Solution temperature: 40-50 °C
Current density: 0.5-5 A/dm$^2$
Plating (current-applying) time: 1-3 seconds
Example 32: not performed

- Chromate treated layer formation process

Examples 29, 31, 32: zinc chromate treatment
Composition of solution: potassium dichromate 1-10 g/L, zinc (added in the form of zinc sulfate) 0.5-5 g/L
pH: 0.5-10
Solution temperature: 30-50 °C
Current density: 0.1-2.6 A/dm$^2$
Amount of coulomb: 0.5-90 As/dm$^2$
Plating (current-applying) time: 1-30 seconds

- Silane coupling-treated layer formation process

Examples 29, 31, 32: The process was carried out in such a manner that a silane coupling agent is applied by spraying an aminosilane solution of pH 7-8 containing 0.2-2 wt% of aminosilane.

- Evaluation test

(Average particle size of primary particle and secondary particle)

For the primary particle layer and the secondary particle layer in the roughened layer of the samples in Examples and Comparative Examples, the average particle size of the primary particles and that of the secondary particles were measured. Note that when a surface treatment layer other than the primary particle layer and the secondary particle layer, e.g., a heat-resistant layer, a rustproofing layer, a chromate treated layer, and a silane coupling-treated layer, was formed, the average particle size was measured from the surface of the outermost layer of the surface treatment layer (i.e., The measurement was conducted on the surface on the side on which the primary particle layer or the primary particle layer and the secondary particle layer were present after all the surface treatment layers of a copper foil were formed).

The average particle size of the primary particles and that of the secondary particles were measured by measuring the particle size of the primary particle and that of the secondary particle based on photographs obtained after observation and photography of the particles at 30000-fold magnification by using a scanning electron microscope S4700 manufactured by Hitachi High-Technologies Corporation. The arithmetic mean value of the obtained particle size of the primary particles and the arithmetic mean value of the obtained particle size of the secondary particles were regarded as the average particle size of the primary particles and the average particle size of the secondary particles, respectively. Note that in a scanning electron microscope photograph, when a straight line is drawn on a portion of a particle where the length of the straight line on the particle becomes the longest, such a length of the straight line on the particle was defined as the particle size of the particle. The size of the measured field was 13.44 $\mu m^2$ (=4.2 $\mu m \times 3.2$ $\mu m$) per field, and the measurement was conducted in one field. Note that when the particles were observed in a scanning electron microscope photograph, particles that were not overlapped in the photograph and, from among the particles that were

overlapping one another, the particles positioned on the copper foil side (particles found under other particles in the photograph) were determined to be the primary particles, and from among the particles that were overlapping one another, particles that were over other particles were determined to be the secondary particles. The value of the average particle size of the primary particles and the value of the average particle size of the secondary particles were recorded in the field of "PRIMARY PARTICLE SIZE (μm)" and the field of "SECONDARY PARTICLE SIZE (μm)", respectively, in Table 3.

(Measurement of adhesion strength)

A copper-clad laminate was manufactured by attaching each of the samples in Examples and Comparative Examples to a resin substrate provided in Table 3 on the side of the roughened layer by hot pressing, a 10-mm circuit was manufactured by using a typical copper chloride circuit etching solution, and the 10-mm circuit copper foil was detached from the substrate. The normal peel strength was measured while pulling the 10-mm circuit copper foil in the 90° direction. Note that in the examples in which a low dielectric polyimide resin substrate or a cyclo-olefin polymer resin substrate is used as the resin substrate, the copper-clad laminate was manufactured by attaching the sample to the resin substrate by hot pressing using a low dielectric adhesive, and the normal peel strength was measured in the manner described above. Note that when the sample is a carrier-attached copper foil, after manufacturing a copper-clad laminate, a carrier is detached from the carrier-attached copper foil. Afterwards, the normal peel strength was measured in the manner described above.

(Surface roughness Ra and Rz)

The surface roughness Ra (arithmetic mean roughness) and the surface roughness Rz (ten point average roughness) of the surface on the roughened layer side of the samples in Examples and Comparative Examples were measured in accordance with the method specified in JIS B0601-1982 by using a stylus roughness measurement device Surfcorder Model SE-3C manufactured by Kosaka Laboratory Ltd. Ra and Rz were measured at randomly selected ten sites, and the average value of the Ra and Rz measured at the ten sites were defined as the surface roughness Ra of the surface on the side of the primary particle layer and the surface roughness Rz of the surface on the side of the primary particle layer.

In the ultra-thin copper layer of the copper foil or the carrier-attached copper foil used in Examples and Comparative Examples, Ra and Rz of the surface on the side on which a roughening treatment is to be carried out were also measured in the manner described above before roughening treatment. Note that the measurement of Ra and Rz was carried out in the TD direction (the width direction, or a direction perpendicular to a direction (MD direction) to which a copper foil or a carrier-attached copper foil moves in a copper foil manufacturing machine or a carrier-attached copper foil manufacturing machine).

(Measurement of transmission loss)

The surface on the roughened layer side of each of the samples in Examples and Comparative Examples was attached to a resin substrate (LCP: a liquid crystal polymer resin (Vecstar CTZ manufactured by KURARAY CO., LTD.), 50μm thick, a resin that is a copolymer of hydroxybenzoic acid (ester) and hydroxynaphthoic acid, or PTFE : a fluororesin (a polytetrafluoroethylene resin), 50μm thick, or low dielectric PI: a low dielectric polyimide resin, 50μm thick, (the low dielectric PI was attached to the copper foil of the sample by a low dielectric adhesive) or COP: cyclo-olefin polymer, 50μm thick, (COP was attached to the copper foil of the sample by a low dielectric adhesive)) recorded in the field of "LAMINATED RESIN SUBSTRATE" in Table 3, and afterwards, when the thickness of the sample was less than 18 μm, copper plating was performed on the sample or when the thickness of the samples was 18 μm or more, the copper thickness of the sample (when the sample was copper-plated, the copper thickness was both the thickness of the sample and the thickness of the copper plating) was made to be 18 μm by soft etching. Afterwards, a microstrip line was formed on the sample that was attached to the above-described resin substrate by means of etching so that the characteristic impedance becomes 50 Ω. The passing power was measured by using a network analyzer N5247A manufactured by Agilent Co. to obtain the transmission loss at a frequency of 60 GHz. Note that the dielectric constant of the resin substrate used in the above-described measurement was 2.9 (when the resin substrate was LCP or PTFE), was 3.2 (when the resin substrate was the low dielectric PI), or was 2.4 (when the resin substrate was COP) . The dielectric tangent of the resin substrate was 0.002 (when the resin substrate was LCP, PTFE, or the low dielectric PI) or was 0.001 (when the resin substrate was COP). The dielectric constant and the dielectric tangent of the resin substrate were measured in the following manner. Each sample was attached to the above-described resin substrate so that the surface on the roughened layer side faces the resin substrate to make a copper-clad laminate, and afterwards, the dielectric constant and the dielectric tangent of the resin substrate when the signal frequency was 1 GHz were measured by the triplate-line resonator method in accordance with "A test method for copper-clad laminates for printed wiring boards dielectric constant and dissipation factor" JPCA-TM001-2007 published by Japan Electronics Packaging and Circuits Association.

(Measurement of deposition amount of Co and Ni)

The deposition amount of Co and the deposition amount of Ni were measured by dissolving the sample of the copper foil or the sample of the ultra-thin copper layer of the carrier-attached copper foil used in Examples and Comparative Examples in a nitric acid aqueous solution at 20 mass% concentration and by analyzing by ICP-AES (Inductively coupled plasma atomic emission spectroscopy). In Examples and Comparative Examples that used a copper foil having a roughened layer on each of both faces, one face of the copper foil was masked with an acid-proof tape etc., and the roughened layer on another face was dissolved to measure the deposition amount of Co and the deposition amount of Ni. Afterwards, the masking was removed and the deposition amount of Co and the deposition amount of Ni on the masked face were measured, or the deposition amount of Co and the deposition amount of Ni were measured by using another sample. In Examples and Comparative Examples that used a carrier-attached copper foil, after detaching a carrier from the carrier-attached copper foil, the exposed surface of the ultra-thin copper layer was masked with an acid-proof tape etc., and the roughened layer of the ultra-thin copper foil on a face opposite to the carrier was dissolved to measure the deposition amount of Co and the deposition amount of Ni. Note that the value provided in Table 3 are the values of one face. In the copper foil having a roughened layers on each of both faces, the deposition amount of Co and the deposition amount of Ni were the same on both faces. Note that when Co, Ni, or other element (s) do (es) not dissolve in a nitric acid aqueous solution at 20 mass% concentration, any solution that can dissolve Co, Ni, or other element(s) may be used and after dissolving Co, Ni, or other element(s), the deposition amounts may be measured by ICP-AES(Inductively coupled plasma atomic emission spectroscopy) as described above. Note that the solution that can dissolve Co, Ni, or other element(s) may be a solution known in the art, an acidic solution known in the art, or an alkaline solution known in the art.

It should be noted that when the copper foil or the carrier-attached copper foil has one or more surface treated layer (s) other than a roughened layer, the total content of Co and Ni in the roughened layer refers to the total content of Co and Ni in the roughened layer and Co and Ni in the surface treated layer (s) other than the roughened layer. In the above case, the content of Co in the roughened layer refers to the total content of Co in the roughened layer and Co in the surface treated layer (s) other than the roughened layer. In the above case, the content of Ni in the roughened layer refers to the total content of Ni in the roughened layer and Ni in the surface treated layer (s) other than the roughened layer. The surface treated layer (s) other than the roughened layer may include a heat-resistant layer, a rustproofing layer, a chromate treated layer, and a silane coupling-treated layer etc.

The above-described test conditions and evaluation results are provided in Tables 1 to 3.

[Table 1]

| | THICKNESS OF COPPER FOIL OR ULTRA-THIN COPPER LAYER (μm) | SURFACE ROUGHNESS Ra OF COPPER FOIL BEFORE SURFACE TREATMENT (μm) | SURFACE ROUGHNESS Rz OF COPPER FOIL BEFORE SURFACE TREATMENT (μm) | PRIMARY PARTICLE LAYER FORMING CONDITION (1) | | | | |
|---|---|---|---|---|---|---|---|---|
| | | | | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 1 | 12 | 0.08 | 0.59 | Cu:13g/l, H2SO4:70g/l | 36 | 51 | 1.50 | 76.6 |
| EXAMPLE 2 | 2 | 0.09 | 0.63 | Cu:13g/l, H2SO4:70g/l | 36 | 51 | 1.31 | 67.0 |
| EXAMPLE 3 | 12 | 0.08 | 0.59 | Cu:13g/l, H2SO4:70g/l | 36 | 51 | 1.38 | 70.2 |
| EXAMPLE 4 | 12 | 0.08 | 0.59 | Cu:13g/l, H2SO4:70g/l | 36 | 51 | 1.31 | 67.0 |
| EXAMPLE 5 | 3 | 0.10 | 0.61 | Cu:13g/l, H2SO4:70g/l | 36 | 51 | 1.39 | 71.0 |
| EXAMPLE 6 | 18 | 0.09 | 0.62 | Cu:13g/l, H2SO4:70g/l | 36 | 51 | 1.44 | 73.4 |
| EXAMPLE 7 | 18 | 0.06 | 0.45 | Cu:13g/l, H2SO4:10g/l | 36 | 51 | 1.19 | 60.6 |
| EXAMPLE 8 | 18 | 0.06 | 0.45 | Cu:13g/l, H2SO4:70g/l | 36 | 51 | 1.13 | 57.4 |
| EXAMPLE 9 | 18 | 0.06 | 0.45 | Cu:13g/l, H2SO4: 70g/l | 36 | 51 | 1.19 | 60.6 |
| EXAMPLE 10 | 12 | 0.06 | 0.43 | Cu:13g/l, H2SO4:70g/l | 36 | 51 | 1.06 | 54.2 |
| EXAMPLE 11 | 12 | 0.06 | 0.41 | Cu:13g/l, H2SO4:70g/l | 36 | 51 | 1.00 | 51.0 |
| EXAMPLE 12 | 18 | 0.06 | 0.43 | Cu:13g/l, H2SO4:70g/l | 36 | 51 | 1.13 | 57.4 |
| EXAMPLE 13 | 18 | 0.06 | 0.37 | Cu:13g/l, H2SO4:70g/l | 36 | 51 | 0.88 | 44.7 |

(continued)

| | THICKNESS OF COPPER FOIL OR ULTRA-THIN COPPER LAYER (μm) | SURFACE ROUGHNESS Ra OF COPPER FOIL BEFORE SURFACE TREATMENT (μm) | SURFACE ROUGHNESS Rz OF COPPER FOIL BEFORE SURFACE TREATMENT (μm) | PRIMARY PARTICLE LAYER FORMING CONDITION (1) | | | | |
|---|---|---|---|---|---|---|---|---|
| | | | | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 14 | 9 | 0.05 | 0.31 | Cu:13g/l, H2SO4:70g/l | 36 | 51 | 0.88 | 44.7 |
| EXAMPLE 15 | 9 | 0.05 | 0.31 | Cu:13g/l, H2SO4:70g/l | 36 | 51 | 0.81 | 41.5 |
| EXAMPLE 16 | 18 | 0.06 | 0.37 | Cu:13g/l, H2SO4:70g/l | 36 | 51 | 0.75 | 38.3 |
| EXAMPLE 17 | 18 | 0.06 | 0.37 | Cu:13g/l, H2SO4:70g/l | 36 | 51 | 0.94 | 47.9 |
| EXAMPLE 18 | 18 | 0.06 | 0.37 | Cu:13g/l, H2SO4:70g/l | 36 | 51 | 0.63 | 31.9 |
| EXAMPLE 19 | 12 | 0.05 | 0.35 | Cu:13g/l, H2SO4:70g/l | 36 | 51 | 1.31 | 67.0 |
| EXAMPLE 20 | 12 | 0.05 | 0.35 | Cu:13g/l, H2SO4:70g/l | 36 | 51 | 1.31 | 67.0 |
| EXAMPLE 21 | 12 | 0.05 | 0.35 | Cu:13g/l, H2SO4:70g/l | 36 | 51 | 1.31 | 67.0 |
| EXAMPLE 22 | 18 | 0.06 | 0.37 | Cu:13g/l, H2SO4:70g/l | 36 | 51 | 0.63 | 31.9 |
| EXAMPLE 23 | 9 | 0.04 | 0.36 | Cu:13g/l, H2SO4:70g/l | 36 | 51 | 0.63 | 31.9 |
| EXAMPLE 24 | 12 | 0.08 | 0.66 | Cu:13g/l, H2SO4:70g/l | 36 | 51 | 1.50 | 76.6 |
| EXAMPLE 25 | 12 | 0.05 | 0.35 | Cu:13g/l, H2SO4:70g/l | 36 | 51 | 1.31 | 67.0 |
| EXAMPLE 26 | 12 | 0.05 | 0.35 | Cu:13g/l, H2SO4:70g/l | 36 | 51 | 1.31 | 67.0 |

(continued)

| | THICKNESS OF COPPER FOIL OR ULTRA-THIN COPPER LAYER (μm) | SURFACE ROUGHNESS Ra OF COPPER FOIL BEFORE SURFACE TREATMENT (μm) | SURFACE ROUGHNESS Rz OF COPPER FOIL BEFORE SURFACE TREATMENT (μm) | **PRIMARY PARTICLE LAYER FORMING CONDITION (1)** | | | | |
|---|---|---|---|---|---|---|---|---|
| | | | | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 27 | 12 | 0.05 | 0.35 | Cu:13g/l, H2SO4:70g/l | 36 | 51 | 1.31 | 67.0 |
| EXAMPLE 28 | 12 | 0.05 | 0.35 | Cu:13g/l, W:10mg/l, H2SO4:70g/l | 36 | 51 | 1.31 | 67.0 |
| EXAMPLE 29 | 12 | 0.08 | 0.66 | Cu:13g/l, H2SO4:70g/l | 36 | 51 | 1.50 | 76.6 |
| EXAMPLE 30 | 18 | 0.06 | 0.71 | Cu:13g/l, H2SO4:70g/l | 36 | 51 | 1.05 | 53.5 |
| EXAMPLE 31 | 12 | 0.08 | 0.66 | Cu:13g/l, H2SO4:70g/l | 36 | 51 | 1.50 | 76.6 |
| EXAMPLE 32 | 18 | 0.08 | 0.62 | Cu:13g/l, H2SO4:10g/l | 36 | 51 | 1.44 | 73.4 |
| EXAMPLE 33 | 18 | 0.07 | 0.72 | Cu:13g/l, H2SO4:70g/l | 36 | 51 | 1.04 | 53.0 |
| EXAMPLE 34 | 18 | 0.07 | 0.74 | Cu:13g/l, H2SO4:70g/l | 36 | 51 | 1.03 | 52.4 |
| EXAMPLE 35 | 12 | 0.08 | 0.56 | Cu:13g/l, H2SO4:70g/l | 36 | 51 | 1.31 | 67.0 |
| EXAMPLE 3 | 12 | 0.08 | 0.58 | Cu:13g/l, H2SO4:70g/l | 36 | 51 | 1.56 | 79.8 |
| EXAMPLE 37 | 12 | 0.05 | 0.35 | Cu:13g/l, H2SO4:70g/l | 36 | 51 | 1.31 | 67.0 |
| EXAMPLE 38 | 12 | 0.05 | 0.35 | Cu:13g/l, H2SO4:70g/l | 36 | 51 | 1.31 | 67.0 |

(continued)

| | THICKNESS OF COPPER FOIL OR ULTRA-THIN COPPER LAYER (μm) | SURFACE ROUGHNESS Ra OF COPPER FOIL BEFORE SURFACE TREATMENT (μm) | SURFACE ROUGHNESS Rz OF COPPER FOIL BEFORE SURFACE TREATMENT (μm) | PRIMARY PARTICLE LAYER FORMING CONDITION (1) | | | | |
|---|---|---|---|---|---|---|---|---|
| | | | | PLATING SOLUTION COMPOSITION | PLATING SOLUTION TEMPERATURE (°C) | CURRENT DENSITY (A/$dm^2$) | PLATING TIME (s) | AMOUNT OF COULOMB (As/$dm^2$) |
| EXAMPLE 39 | 12 | 0.05 | 0.35 | Cu:13g/l, H2SO4:70g/l | 36 | 51 | 1.31 | 67.0 |
| EXAMPLE 40 | 12 | 0.05 | 0.35 | Cu:13g/l, H2SO4:70g/l | 36 | 51 | 1.31 | 67.0 |
| EXAMPLE 41 | 12 | 0.05 | 0.35 | Cu:13g/l, H2SO4:70g/l | 36 | 51 | 1.31 | 67.0 |
| COMPARATIVE EXAMPLE 1 | 12 | 0.08 | 0.66 | Cu:13g/l, H2SO4:70g/l | 36 | 51 | 1.63 | 83.0 |
| COMPARATIVE EXAMPLE 2 | 12 | 0.08 | 0.66 | Cu:13g/l, H2SO4:70g/l | 36 | 51 | 1.81 | 92.5 |
| COMPARATIVE EXAMPLE 3 | 3 | 0.12 | 0.72 | Cu:13g/l, H2SO4:70g/l | 36 | 49 | 1.00 | 49.0 |
| COMPARATIVE EXAMPLE 4 | 18 | 0.04 | 0.32 | Cu:13g/l, H2SO4:70g/l | 36 | 51 | 0.56 | 28.7 |
| COMPARATIVE EXAMPLE 5 | 12 | 0.10 | 0.51 | Cu:13g/l, H2SO4:70g/l | 36 | 51 | 1.57 | 80.0 |
| COMPARATIVE EXAMPLE 6 | 18 | 0.15 | 0.75 | Cu:15g/l, H2SO4:75g/l | 35 | 47 | 1.40 | 66.0 |

[Table 2]

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 1 | Cu:25g/l, H2SO4:85g/l | 42 | 6 | 2.67 | 16.0 | Cu:13g/l, Co:9g/l, Ni:9g/l, pH 3.0 | 37 | 31 | 1.10 | 34.1 |
| EXAMPLE 2 | Cu:25g/l, H2SO4:85g/l | 42 | 8 | 2.00 | 16.0 | Cu:13g/l, Co:9g/l, Ni:9g/l, pH 3.0 | 37 | 32 | 1.07 | 34.1 |
| EXAMPLE 3 | Cu:25g/l, H2SO4:85g/l | 42 | 6 | 2.67 | 16.0 | Cu:13g/l, Co:9g/l, Ni:9g/l, pH 3.0 | 37 | 31 | 1.18 | 36.7 |
| EXAMPLE 4 | Cu:25g/l, H2SO4:85g/l | 42 | 8 | 2.00 | 16.0 | Cu:13g/l, Co:9g/l, Ni:9g/l, pH 3.0 | 37 | 32 | 1.02 | 32.6 |
| EXAMPLE 5 | Cu:25g/l, H2SO4:85g/l | 42 | 6 | 2.67 | 16.0 | Cu:13g/l, Co:9g/l, Ni:9g/l, pH 3.0 | 37 | 31 | 0.94 | 29.1 |
| EXAMPLE 6 | Cu:25g/l, H2SO4:85g/l | 42 | 6 | 2.67 | 16.0 | - | - | | - | - |
| EXAMPLE 7 | Cu:25g/l, H2SO4:85g/l | 42 | 8 | 1.75 | 14.0 | Cu:13g/l, Co:9g/l, Ni:9g/l, pH 3.0 | 37 | 32 | 0.62 | 19.9 |
| EXAMPLE 8 | Cu:25g/l, H2SO4:85g/l | 42 | 8 | 1.75 | 14.0 | Cu:13g/l, Co:9gl, Ni:9g/l, pH 3.0 | 37 | 32 | 0.98 | 31.4 |
| EXAMPLE 9 | Cu:25g/l, H2SO4:85g/l | 42 | 8 | 1.75 | 14.0 | Cu:13g/l, Co:9g/l, Ni:9g/l, pH 3.0 | 37 | 32 | 0.71 | 22.7 |
| EXAMPLE 10 | Cu:25g/l, H2SO4:85g/l | 42 | 8 | 1.75 | 14.0 | Cu:13g/l, Co:9g/l, Ni:9g/l, pH 3.0 | 37 | 32 | 0.66 | 21.1 |

(continued)

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 11 | Cu:25g/l, H2SO4:85g/l | 42 | 8 | 1.50 | 12.0 | Cu:13g/l, Co:9g/l, Ni:9g/l, pH 3.0 | 37 | 32 | 0.57 | 18.1 |
| EXAMPLE 12 | Cu:25g/l, H2SO4:85g/l | 42 | 8 | 1.75 | 14.0 | - | - | | - | - |
| EXAMPLE 13 | Cu:25g/l, H2SO4:85g/l | 42 | 8 | 1.50 | 12.0 | Cu:13g/l, Co:9g/l, Ni:9g/l, pH 3.0 | 37 | 32 | 0.79 | 25.3 |
| EXAMPLE 14 | Cu:25g/l, H2SO4:85g/l | 42 | 8 | 1.50 | 12.0 | - | - | | - | - |
| EXAMPLE 15 | Cu:25g/l, H2SO4:85g/l | 42 | 8 | 150 | 12.0 | Cu:13g/l, Co:9g/l, Ni:9g/l, pH 3.0 | 37 | 32 | 0.70 | 22.4 |
| EXAMPLE 16 | Cu:25g/l, H2SO4:85g/l | 42 | 8 | 1.50 | 12.0 | Cu:13g/l, Co:9g/l, Ni:9g/l, pH 3.0 | 37 | 32 | 0.68 | 21.9 |
| EXAMPLE 17 | Cu:25g/l, H2SO4:85g/l | 42 | 8 | 1.50 | 12.0 | Cu:13g/l, Co:9g/l, Ni:9g/l, pH 3.0 | 37 | 32 | 1.13 | 36.1 |
| EXAMPLE 18 | Cu:25g/l, H2SO4:85g/l | 42 | 8 | 1.50 | 12.0 | Cu:13g/l, Co:9g/l, Ni:9g/l, pH 3.0 | 37 | 32 | 0.66 | 21.1 |
| EXAMPLE 19 | Cu:25g/l, H2SO4:85g/l | 42 | 8 | 2.00 | 16.0 | Cu:13g/l, Co:9g/l, Ni:9g/l, pH 3.0 | 37 | 32 | 1.03 | 33.0 |

(continued)

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 20 | Cu:25g/l, H2SO4:85g/l | 42 | 8 | 2.00 | 16.0 | Cu:13g/l, Co:9g/l, Ni:9g/l, pH 3.0 | 37 | 32 | 0.36 | 11.5 |
| EXAMPLE 21 | Cu:25g/l, H2SO4:85g/l | 42 | 8 | 2.00 | 16.0 | Cu:13g/l, Co:9g/l, Ni:9g/l, pH 3.0 | 37 | 32 | 0.23 | 7.2 |
| EXAMPLE 22 | Cu:25g/l, H2SO4:85g/l | 42 | 8 | 1.50 | 12.0 | Cu:13g/l, Co:9g/l, Ni:9g/l, pH 3.0 | 37 | 32 | 0.38 | 12.1 |
| EXAMPLE 23 | Cu:25g/l, H2SO4:85g/l | 42 | 8 | 1.50 | 12.0 | Cu:13g/l, Co:9g/l, Ni:9g/l, pH 3.0 | 37 | 32 | 0.23 | 7.4 |
| EXAMPLE 24 | Cu:25g/l, H2SO4:85g/l | 42 | 6 | 2.67 | 16.0 | Cu:13g/l, Co:9g/l, Ni:9g/l, pH 3.0 | 37 | 31 | 1.14 | 35.3 |
| EXAMPLE 25 | Cu:25g/l, H2SO4:85g/l | 42 | 8 | 2.00 | 16.0 | Cu:13g/l, Co:9g/l, Ni:9g/l, pH 3.0 | 37 | 32 | 1.03 | 32.9 |
| EXAMPLE 26 | Cu:25g/l, H2SO4:85g/l | 42 | 8 | 2.00 | 16.0 | Cu:13g/l, Co:10g/l, pH 3.0 | 37 | 32 | 0.75 | 23.9 |
| EXAMPLE 27 | Cu:25g/l, H2SO4:85g/l | 42 | 8 | 2.00 | 16.0 | Cu:13g/l, Ni:10g/l, pH 3.0 | 37 | 32 | 0.36 | 11.4 |
| EXAMPLE 28 | Cu:25g/l, H2SO4:85g/l | 42 | 8 | 2.00 | 16.0 | Cu:13g/l, Co:9g/l, Ni:9g/l, pH 3.0 | 37 | 32 | 1.05 | 33.7 |

(continued)

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 29 | Cu:25g/l, H2SO4:85g/l | 42 | 6 | 2.67 | 16.0 | Cu:13g/l, Co:9g/l, Ni:9g/l, pH 3.0 | 37 | 31 | 1.32 | 40.9 |
| EXAMPLE 30 | Cu:25g/l, H2SO4:85g/l | 42 | 8 | 1.75 | 14.0 | Cu:13g/l, Co:9g/l, Ni:9g/l, pH 3.0 | 37 | 45 | 1.62 | 73.1 |
| EXAMPLE 31 | Cu25g/l, H2SO4:85g/l | 42 | 6 | 2.67 | 16.0 | Cu:16g/l, Co:7g/l, Ni:7g/l, pH 3.0 | 37 | 45 | 1.63 | 73.4 |
| EXAMPLE 32 | Cu:25g/l, H2SO4:85g/l | 42 | 6 | 2.67 | 16.0 | - | - | | - | - |
| EXAMPLE 33 | Cu:25g/l, H2SO4:85g/l | 42 | 8 | 1.75 | 14.0 | Cu:13g/l, Co:9g/l, Ni:9g/l, pH 3.0 | 37 | 45 | 1.55 | 69.9 |
| EXAMPLE 34 | Cu:25g/l, H2SO4:85g/l | 42 | 8 | 1.75 | 14.0 | Cu:13g/l, Co:9g/l, Ni:9g/l, pH 3.0 | 37 | 44 | 1.64 | 72.1 |
| EXAMPLE 35 | Cu:25g/l, H2SO4:85g/l | 42 | 8 | 2.00 | 16.0 | Cu:13g/l, Co:9g/l, Ni:9g/l, pH 3.0 | 37 | 44 | 1.66 | 73.1 |
| EXAMPLE 3 | Cu:25g/l, H2SO4:85g/l | 42 | 6 | 2.67 | 16.0 | Cu:13g/l, Co:9g/l, Ni:9g/l, pH 3.0 | 37 | 31 | 1.19 | 36.9 |
| EXAMPLE 37 | Cu:25g/l, H2SO4:85g/l | 42 | 8 | 2.00 | 16.0 | Cu:13g/l, Ni:9g/l, P:1g/l, pH 3.0 | 37 | 32 | 0.33 | 10.6 |

(continued)

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) | PLATING SOLUTION COMPOSITION | PLATING SOLUTION TEMPERATURE (°C) | CURRENT DENSITY ($A/dm^2$) | PLATING TIME (s) | AMOUNT OF COULOMB ($As/dm^2$) |
| EXAMPLE 38 | Cu:25g/l, H2SO4:85g/l | 42 | 8 | 2.00 | 16.0 | Cu:13g/l, Ni:9g/l, Mo:2g/l, W:3mg/l, pH 3.0 | 37 | 32 | 0.29 | 9.4 |
| EXAMPLE 39 | Cu:25g/l, H2SO4:85g/l | 42 | 8 | 2.00 | 16.0 | Cu:13g/l, Ni:9g/l, Fe:1g/l, Zn:1g/l, pH 3.0 | 37 | 32 | 0.31 | 9.8 |
| EXAMPLE 40 | Cu:25g/l, H2SO4:85g/l | 42 | 8 | 2.00 | 16.0 | Cu:13g/l, Co:9g/l, Cr:1g/l, Ti:1g/l, pH 3.0 | 37 | 32 | 0.73 | 23.2 |
| EXAMPLE 41 | Cu:25g/l, H2SO4:85g/l | 42 | 8 | 2.00 | 16.0 | Cu:13g/l, Co:9g/l, As:0.1g/l, pH 3.0 | 37 | 32 | 0.71 | 22.7 |
| COMPARATIVE EXAMPLE 1 | Cu:25g/l, H2SO4:85g/l | 42 | 6 | 2.67 | 16.0 | Cu:13g/l, Co:9g/l, Ni:9g/l, pH 3.0 | 37 | 31 | 1.43 | 44.4 |
| COMPARATIVE EXAMPLE 2 | Cu:25g/l, H2SO4:85g/l | 42 | 5 | 3.60 | 18.0 | - | - | - | - | - |
| COMPARATIVE EXAMPLE 3 | Cu:25g/l, H2SO4:85g/l | 42 | 6 | 1.67 | 10.0 | Cu:13g/l, Co:9g/l, Ni:9g/l, pH 3.0 | 37 | 25 | 2.75 | 68.8 |
| COMPARATIVE EXAMPLE 4 | Cu:25g/l, H2SO4:85g/l | 42 | 8 | 1.50 | 12.0 | Cu:13g/l, Co:9g/l, Ni:9g/l, pH 3.0 | 37 | 32 | 0.62 | 19.8 |
| COMPARATIVE EXAMPLE 5 | Cu:25g/l, H2SO4:85g/l | 42 | 6 | 2.67 | 16.0 | cu:13g/l, Co:9g/l, Ni:9g/l, pH 3.0 | 37 | 31 | 1.51 | 46.7 |

(continued)

| | PRIMARY PARTICLE LAYER FORMING CONDITION (2) | | | | | SECONDARY PARTICLE LAYER FORMING CONDITION | | | | |
|---|---|---|---|---|---|---|---|---|---|---|
| | PLATING SOLUTION COMPOSITION | PLATING SOLUTION TEMPERATURE (°C) | CURRENT DENSITY (A/dm$^2$) | PLATING TIME (s) | AMOUNT OF COULOMB (As/dm$^2$) | PLATING SOLUTION COMPOSITION | PLATING SOLUTION TEMPERATURE (°C) | CURRENT DENSITY (A/dm$^2$) | PLATING TIME (s) | AMOUNT OF COULOMB (As/dm$^2$) |
| COMPARATIVE EXAMPLE 6 | Cu:15g/l, H2SO4:75g/l | 35 | 1 | 4.00 | 4.0 | Cu:15g/l, Co:8g/l, Ni:8g/l, pH 2.0 | 40 | 24 | 1.42 | 34.0 |

[Table 3]

| | PRIMARY PARTICLE SIZE (μm) | SECONDARY PARTICLE SIZE (μm) | DEPOSITION AMOUNT OF Co IN ROUGHENED LAYER (μg/dm$^2$) | DEPOSITION AMOUNT OF Ni IN ROUGHENED LAYER (μg/dm$^2$) | TOTAL DEPOSITION AMOUNT OF Co AND Ni IN ROUGHENED LAYER (μg/dm$^2$) | ADHESION STRENGTH MEASUREMENT | | STYLUS ROUGHNESS | | TRANSMISSION LOSS AT 60 GHz |
|---|---|---|---|---|---|---|---|---|---|---|
| | | | | | | LAMINATED RESIN SUBSTRATE | NORMAL PEEL STRENGTH (kN/m) | Ra (μm) | Rz (μm) | dB/10cm |
| EXAMPLE 1 | 0.24 | 0.25 | 821 | 110 | 931 | LCP | 1.08 | 0.10 | 0.73 | -8.30 |
| EXAMPLE 2 | 0.21 | 0.24 | 830 | 102 | 932 | LCP | 1.17 | 0.11 | 0.72 | -8.36 |
| EXAMPLE 3 | 0.22 | 0.25 | 849 | 140 | 989 | LCP | 0.94 | 0.11 | 0.70 | -0.26 |
| EXAMPLE 4 | 0.21 | 0.23 | 795 | 98 | 893 | LCP | 1.03 | 0.10 | 0.70 | -8.28 |
| EXAMPLE 5 | 0.25 | 0.31 | 660 | 130 | 790 | LCP | 1.04 | 0.12 | 0.71 | -8.36 |
| EXAMPLE 6 | 0.23 | - | 0 | 0 | 0 | PTFE | 0.86 | 0.10 | 0.71 | -8.27 |
| EXAMPLE 7 | 0.19 | 0.14 | 484 | 60 | 544 | PTFE | 0.91 | 0.09 | 0.59 | -8.25 |
| EXAMPLE 8 | 0.18 | 0.22 | 761 | 94 | 854 | PTFE | 1.19 | 0.08 | 0.63 | -8.27 |
| EXAMPLE 9 | 0.19 | 0.16 | 553 | 68 | 621 | PTFE | 1.07 | 0.09 | 0.58 | -8.32 |
| EXAMPLE 10 | 0.17 | 0.15 | 519 | 64 | 583 | LCP | 1.14 | 0.08 | 0.56 | -8.30 |
| EXAMPLE 11 | 0.16 | 0.13 | 450 | 55 | 505 | LCP | 0.90 | 0.07 | 0.51 | -8.32 |
| EXAMPLE 12 | 0.18 | - | 0 | 0 | 0 | PTFE | 0.99 | 0.08 | 0.49 | -8.23 |
| EXAMPLE 13 | 0.14 | 0.18 | 623 | 77 | 699 | PTFE | 0.96 | 0.07 | 0.49 | -8.30 |
| EXAMPLE 14 | 0.14 | - | 0 | 0 | 0 | PTFE | 0.92 | 0.07 | 0.47 | -8.17 |
| EXAMPLE 15 | 0.13 | 0.15 | 545 | 78 | 623 | PTFE | 0.89 | 0.07 | 0.44 | -8.17 |
| EXAMPLE 16 | 0.12 | 0.15 | 534 | 72 | 606 | PTFE | 0.84 | 0.06 | 0.45 | -8.12 |
| EXAMPLE 17 | 0.15 | 0.25 | 865 | 106 | 971 | PTFE | 0.83 | 0.06 | 0.46 | -8.21 |
| EXAMPLE 18 | 0.10 | 0.15 | 519 | 64 | 583 | PTFE | 0.80 | 0.07 | 0.47 | -8.07 |
| EXAMPLE 19 | 0.20 | 0.19 | 620 | 270 | 890 | LCP | 0.90 | 0.06 | 0.45 | -8.24 |
| EXAMPLE 20 | 0.20 | 0.08 | 277 | 34 | 311 | LCP | 0.90 | 0.05 | 0.43 | -8.12 |
| EXAMPLE 21 | 0.20 | 0.05 | 173 | 21 | 194 | LCP | 0.90 | 0.05 | 0.42 | -8.10 |

(continued)

| | PRIMARY PARTICLE SIZE (μm) | SECONDARY PARTICLE SIZE (μm) | DEPOSITION AMOUNT OF Co IN ROUGHENED LAYER (μg/dm$^2$) | DEPOSITION AMOUNT OF Ni IN ROUGHENED LAYER (μg/dm$^2$) | TOTAL DEPOSITION AMOUNT OF Co AND Ni IN ROUGHENED LAYER (μg/dm$^2$) | ADHESION STRENGTH MEASUREMENT | | STYLUS ROUGHNESS | | TRANSMISSION LOSS AT 60 GHz |
|---|---|---|---|---|---|---|---|---|---|---|
| | | | | | | LAMINATED RESIN SUBSTRATE | NORMAL PEEL STRENGTH (kN/m) | Ra (μm) | Rz (μm) | dB/10cm |
| EXAMPLE 22 | 0.10 | 0.09 | 311 | 38 | 350 | PTFE | 0.80 | 0.06 | 0.45 | -8.12 |
| EXAMPLE 23 | 0.10 | 0.05 | 176 | 30 | 206 | PTFE | 0.80 | 0.04 | 0.43 | -8.11 |
| EXAMPLE 24 | 0.24 | 0.25 | 865 | 106 | 971 | LOW DIELECTRIC PI | 1.08 | 0.10 | 0.73 | -8.40 |
| EXAMPLE 25 | 0.20 | 0.17 | 620 | 270 | 890 | COP | 0.90 | 0.06 | 0.45 | -8.13 |
| EXAMPLE 26 | 0.20 | 0.16 | 650 | 0 | 650 | LCP | 0.89 | 0.06 | 0.45 | -8.21 |
| EXAMPLE 27 | 0.20 | 0.07 | 0 | 310 | 310 | LCP | 0.89 | 0.06 | 0.45 | -8.15 |
| EXAMPLE 28 | 0.18 | 0.23 | 629 | 288 | 917 | LCP | 0.90 | 0.05 | 0.45 | -8.24 |
| EXAMPLE 29 | 0.24 | 0.25 | 865 | 250 | 1115 | LCP | 1.09 | 0.10 | 0.73 | -8.37 |
| EXAMPLE 30 | 0.18 | 0.22 | 1368 | 597 | 1965 | PTFE | 1.21 | 0.08 | 0.85 | -8.40 |
| EXAMPLE 31 | 0.24 | 0.26 | 1395 | 574 | 1969 | LCP | 1.09 | 0.11 | 0.74 | -8.39 |
| EXAMPLE 32 | 0.23 | - | 200 | 0 | 200 | PTFE | 0.87 | 0.10 | 0.71 | -8.14 |
| EXAMPLE 33 | 0.18 | 0.25 | 1363 | 601 | 1964 | PTFE | 1.21 | 0.08 | 0.89 | -8.40 |
| EXAMPLE 34 | 0.18 | 0.26 | 1365 | 592 | 1957 | PTFE | 1.22 | 0.08 | 0.93 | -8.39 |
| EXAMPLE 35 | 0.21 | 0.25 | 1390 | 603 | 1993 | LCP | 1.03 | 0.10 | 0.70 | -8.39 |
| EXAMPLE 3 | 0.25 | 0.24 | 865 | 141 | 1006 | LCP | 1.08 | 0.10 | 0.73 | -8.35 |
| EXAMPLE 37 | 0.20 | 0.08 | 0 | 285 | 285 | LCP | 0.90 | 0.06 | 0.45 | -8.17 |
| EXAMPLE 38 | 0.20 | 0.07 | 0 | 260 | 260 | LCP | 0.90 | 0.06 | 0.45 | -8.17 |
| EXAMPLE 39 | 0.20 | 0.07 | 0 | 270 | 270 | LCP | 0.90 | 0.06 | 0.45 | -8.17 |
| EXAMPLE 40 | 0.20 | 0.13 | 630 | 0 | 630 | LCP | 0.90 | 0.06 | 0.45 | -8.24 |
| EXAMPLE 41 | 0.20 | 0.11 | 620 | 0 | 620 | LCP | 0.90 | 0.06 | 0.45 | -8.23 |

(continued)

| | PRIMARY PARTICLE SIZE (μm) | SECONDARY PARTICLE SIZE (μm) | DEPOSITION AMOUNT OF Co IN ROUGHENED LAYER (μg/dm²) | DEPOSITION AMOUNT OF Ni IN ROUGHENED LAYER (μg/dm²) | TOTAL DEPOSITION AMOUNT OF Co AND Ni IN ROUGHENED LAYER (μg/dm²) | ADHESION STRENGTH MEASUREMENT | | STYLUS ROUGHNESS | | TRANSMISSION LOSS AT 60 GHz |
|---|---|---|---|---|---|---|---|---|---|---|
| | | | | | | LAMINATED RESIN SUBSTRATE | NORMAL PEEL STRENGTH (kN/m) | Ra (μm) | Rz (μm) | dB/10cm |
| COMPARATIVE EXAMPLE 1 | 0.26 | 0.30 | 1038 | 173 | 1211 | LCP | 0.97 | 0.13 | 0.77 | -8.43 |
| COMPARATIVE EXAMPLE 2 | 0.29 | - | 0 | 0 | 0 | PTFE | 1.11 | 0.15 | 0.82 | -8.45 |
| COMPARATIVE EXAMPLE 3 | 0·16 | 0.42 | 1453 | 429 | 1882 | LCP | 1.22 | 0.16 | 0.89 | -8.68 |
| COMPARATIVE EXAMPLE 4 | 0.09 | 0.14 | 484 | 60 | 544 | PTFE | 0.58 | 0.05 | 0.41 | -8.01 |
| COMPARATIVE EXAMPLE 5 | 0.25 | 0.30 | 1038 | 226 | 1264 | LCP | 0.97 | 0.13 | 0.69 | -8.42 |
| COMPARATIVE EXAMPLE 6 | 0.15 | 0.05 | 885 | 160 | 1045 | PTFE | 0.81 | 0.18 | 0.87 | -8.47 |

(Evaluation result)

In Examples 1-41, the surface roughness Ra was 0.12 μm or less, the average particle size of the primary particles was 0.10-0.25 μm on the surface on the primary particle layer side. Therefore, the transmission loss was favorably controlled, and the adhesion to a resin was also favorable.
In Comparative Examples 1-3, 5, 6, because the surface roughness Ra exceeded 0.12 μm on the surface on the primary particle layer side, the transmission loss turned out to be unfavorable result.
In Comparative Example 4, the average size of the primary particles was less than 0.10 μm, the adhesion strength to a resin was not favorable.

**Claims**

**1.** A copper foil, comprising a roughened layer,
wherein the roughened layer includes a primary particle layer,
wherein a surface roughness Ra of a surface on a side of the primary particle layer is 0.12 μm or less, and
wherein an average particle size of primary particles of the primary particle layer is 0.10 to 0.25 μm.

**2.** The copper foil according to claim 1,
wherein the roughened layer includes a secondary particle layer on or over the primary particle layer, and
an average particle size of secondary particles of the secondary particle layer is 0.35 μm or less.

**3.** The copper foil according to claim 1 or 2,
wherein an average particle size of primary particles of the primary particle layer satisfies one or both of conditions (3-1) and (3-2) below:

(3-1) the average particle size is less than 0.25 μm; and
(3-2) the average particle size is 0.244 μm or less.

**4.** The copper foil according to any one of claims 1 to 3,
wherein the copper foil satisfies one or two or three of conditions (4-1) to (4-3) below:

(4-1) a circuit is formed by attaching a resin with a dielectric constant being 2.4, a dielectric tangent being 0.001, and a thickness being 50 μm to a surface on a side of the roughened layer of the copper foil, by making the thickness of the copper foil be 18 μm, and by etching the copper foil so that a characteristic impedance of the circuit is 50 Ω, and when transmission loss of the circuit is measured at a frequency of 60 GHz, the transmission loss is 8.4 db/10 cm or less;
(4-2) a circuit is formed by attaching a resin with a dielectric constant being 2.9, a dielectric tangent being 0.002, and a thickness being 50 a surface on a side of the roughened layer of the copper foil, by making the thickness of the copper foil be 18 μm, and by etching the copper foil so that a characteristic impedance of the circuit is 50 Ω, and when transmission loss of the circuit is measured at a frequency of 60 GHz, the transmission loss is 8.4 db/10 cm or less; and (4-3) a circuit is formed by attaching a resin with a dielectric constant being 3.2, a dielectric tangent being 0.002, and a thickness being 50 a surface on a side of the roughened layer of the copper foil, by making the thickness of the copper foil be 18 μm, and by etching the copper foil so that a characteristic impedance of the circuit is 50 Ω, and when transmission loss of the circuit is measured at a frequency of 60 GHz, the transmission loss is 8.4 db/10 cm or less.

**5.** The copper foil according to any one of claims 1 to 4,
wherein the copper foil satisfies one or two or three of conditions (5-1) to (5-3) below:

(5-1) a total content of Co and Ni in the roughened layer is 2000 μg/dm$^2$ or less;
(5-2) a total content of Co in the roughened layer is 1000 μg/dm$^2$ or less; and
(5-3) a total content of Ni in the roughened layer is 1000 μg/dm$^2$ or less.

**6.** The copper foil according to any one of claims 1 to 5,
wherein a surface roughness Rz of a surface on a side of the primary particle layer is 1.6 μm or less.

**7.** The copper foil according to any one of claims 1 to 5,

wherein the copper foil has one or more layer selected from a group of a heat-resistant layer, a rustproofing layer, a chromate treated layer, and a silane coupling-treated layer on a surface of the roughened layer.

**8.** The copper foil according to any one of claims 1 to 7, wherein the copper foil satisfies one or both of conditions (8-1) and (8-2) below:

(8-1) the copper foil has a resin layer on a surface on a side of the roughened layer of the copper foil; and
(8-2) the copper foil has a resin layer on a surface on a side of the roughened layer of the copper foil and the resin layer is an adhesive resin and/or a resin in a semi-cured state.

**9.** The copper foil according to any one of claims 1 to 8,
wherein the copper foil is a copper foil for a high-frequency circuit.

**10.** A carrier-attached copper foil, comprising
an intermediate layer and an ultra-thin copper layer in this order on one or both of surfaces of a carrier,
wherein the ultra-thin copper layer is the copper foil according to any one of claims 1 to 9.

**11.** The carrier-attached copper foil according to claim 10,
wherein the carrier-attached copper foil is a carrier-attached copper foil for a high frequency circuit.

**12.** A laminate comprising the copper foil according to any one of claims 1 to 9 or the carrier-attached copper foil according to claim 10 or 11, or
a laminate comprising a resin and the carrier-attached copper foil according to claim 10 or 11, wherein a portion or entirety of an end face of the carrier-attached copper foil is covered with the resin, or
a laminate wherein a side of the carrier or a side of the ultra-thin copper layer of one carrier-attached copper foil according to claim 10 or 11 is attached to a side of the carrier or a side of the ultra-thin copper layer of another carrier-attached copper foil according to claim 10 or 11.

**13.** A method of manufacturing a printed wiring board by using the copper foil according to any one of claims 1 to 9 or the carrier-attached copper foil according to claim 10 or 11, or
a method of manufacturing a printed wiring board, comprising:

preparing the copper foil according to any one of claims 1 to 9 or the carrier-attached copper foil according to claim 10 or 11, and an insulating substrate;
forming a copper-clad laminate by laminating the copper foil and the insulating substrate, or forming a copper-clad laminate by laminating the carrier-attached copper foil and the insulating substrate and detaching a carrier from the carrier-attached copper foil; and
forming a circuit by any one of a semi-additive method, a subtractive method, a partly additive method, and a modified semi-additive method, or
a method of manufacturing a printed wiring board, comprising:

forming a circuit on a surface on a side of the roughened layer of the copper foil according to any one of claims 1 to 9 or forming a circuit on a surface on a side of the ultra-thin copper layer or a surface on a side of the carrier of the carrier-attached copper foil according to claim 10 or 11;
forming a resin layer on the surface on the side of the roughened layer of the copper foil or on the surface of the side of the carrier of the carrier-attached copper foil so that the circuit is buried;
forming a circuit on the resin layer; and
after forming the circuit on the resin layer, exposing the circuit buried in the resin layer by removing the copper foil or by removing the ultra-thin copper layer or the carrier after detaching the ultra-thin copper layer or the carrier, or
a method of manufacturing a printed wiring board, comprising:

laminating the carrier-attached copper foil according to claim 10 or 11 and a resin substrate;
providing at least once two layers including a resin layer and a circuit on a surface opposite to a side of the carrier-attached copper foil on which the carrier-attached copper foil is attached to the resin substrate; and
after forming the two layers including the resin layer and the circuit, detaching the carrier or the ultra-thin copper layer from the carrier-attached copper foil, or

a method of manufacturing a printed wiring board, comprising:

providing at least once two layers including a resin layer and a circuit on one or both of surfaces of any one of the laminates according to claim 12; and
after forming the two layers including the resin layer and the circuit, detaching the carrier or the ultra-thin copper layer from the carrier-attached copper foil of the laminate.

**14.** A method of manufacturing an electronic device comprising
manufacturing an electronic device by using a printed wiring board manufactured by any one of the methods according to claim 13.

FIG.1

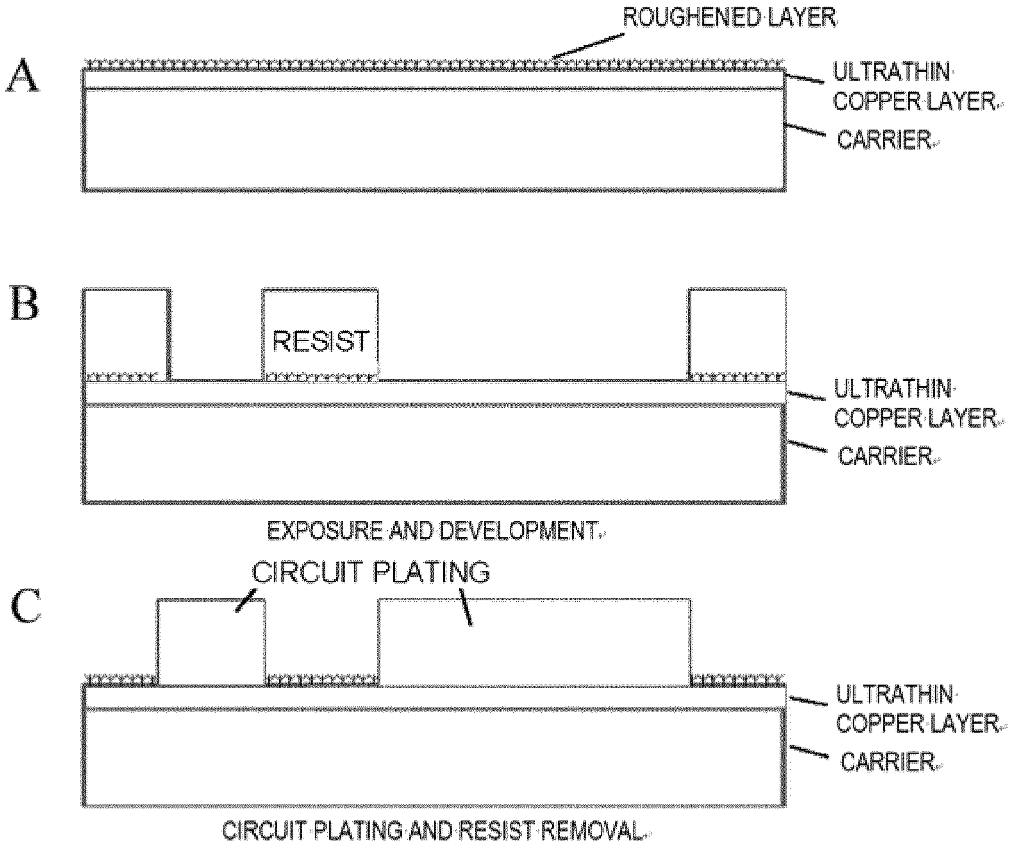
A
ROUGHENED LAYER
ULTRATHIN COPPER LAYER
CARRIER
B
RESIST
ULTRATHIN COPPER LAYER
CARRIER
EXPOSURE AND DEVELOPMENT
C
CIRCUIT PLATING
ULTRATHIN COPPER LAYER
CARRIER
CIRCUIT PLATING AND RESIST REMOVAL

FIG.2

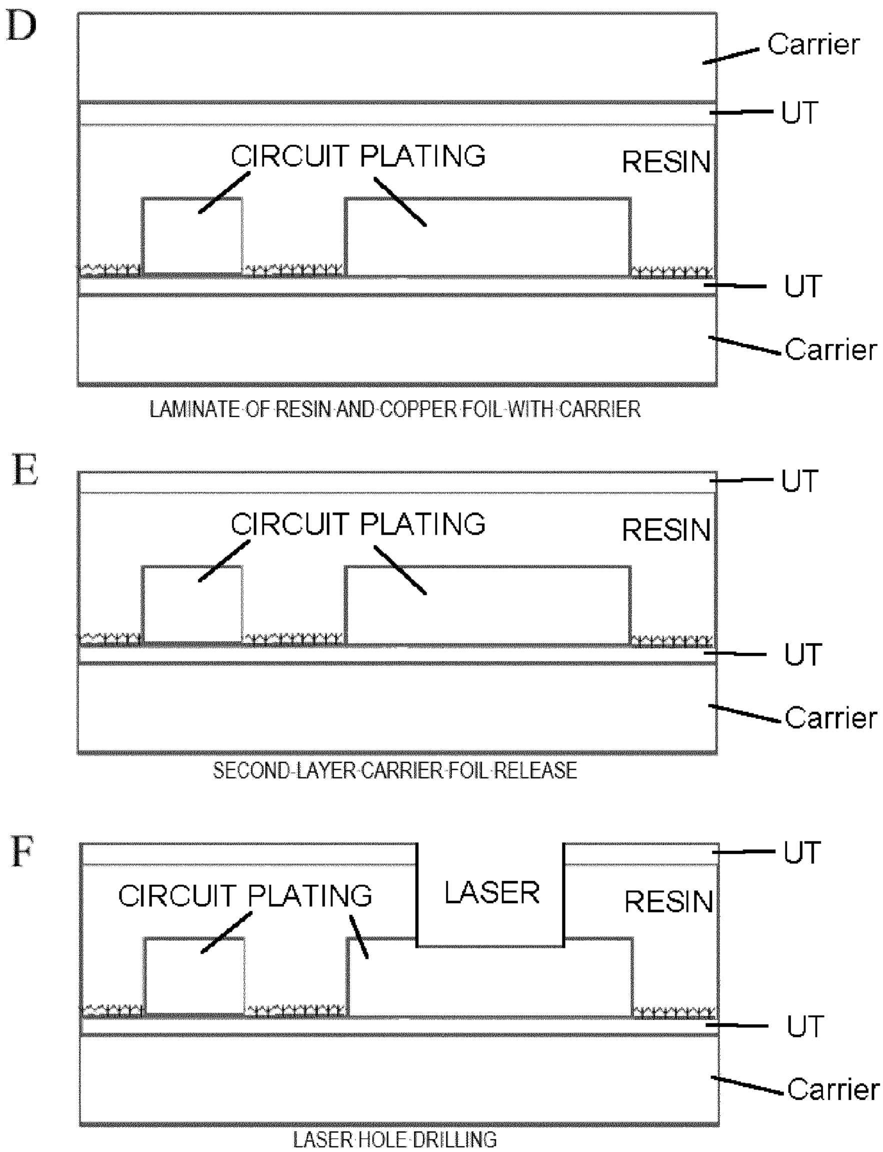
D
Carrier
UT
CIRCUIT PLATING
RESIN
UT
Carrier
LAMINATE OF RESIN AND COPPER FOIL WITH CARRIER
E
UT
CIRCUIT PLATING
RESIN
UT
Carrier
SECOND LAYER CARRIER FOIL RELEASE
F
UT
CIRCUIT PLATING
LASER
RESIN
UT
Carrier
LASER HOLE DRILLING

FIG.3

G

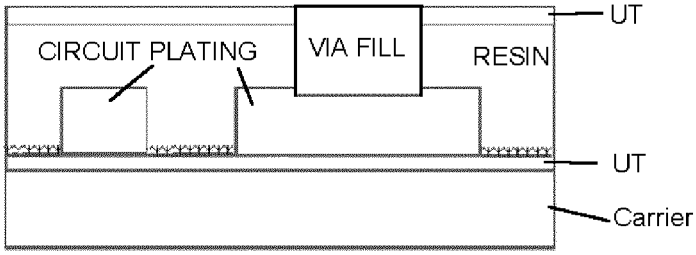


VIA-FILL

H

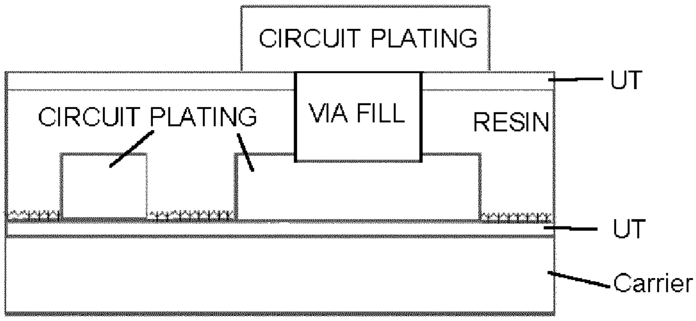


SECOND-LAYER CIRCUIT PLATING

I

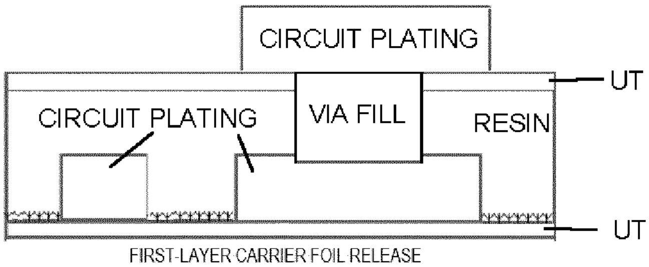


FIRST-LAYER CARRIER FOIL RELEASE

FIG.4

J

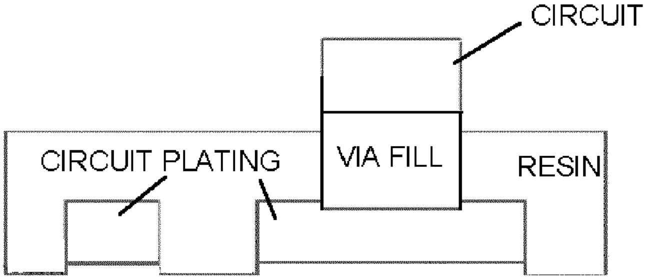


FLASH ETCHING

K

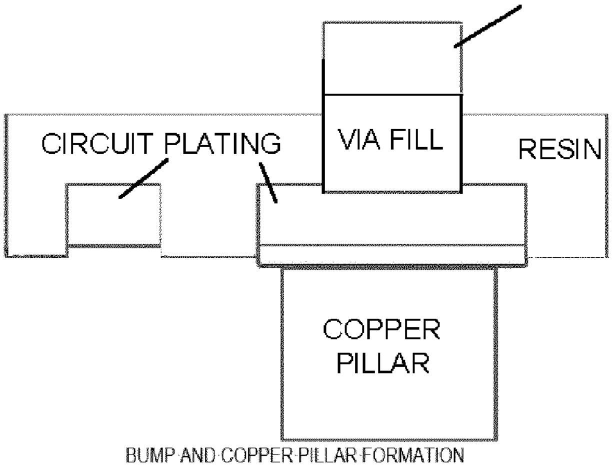


BUMP AND COPPER PILLAR FORMATION

Europäisches Patentamt
European Patent Office
Office européen des brevets

# EUROPEAN SEARCH REPORT

Application Number
EP 17 16 6671

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2012/285734 A1 (UNO TAKEO [JP] ET AL) 15 November 2012 (2012-11-15)<br>* claim 13 *<br>* example 7 *<br>* table 1 *<br>* paragraphs [0002], [0003], [0034], [0035], [0079] *<br>* figure 1 *<br>----- | 1-14 | INV.<br>H05K3/02<br>H05K3/38 |
| Y | WO 2015/012376 A1 (NIPPON MINING & METALS CO LTD) 29 January 2015 (2015-01-29)<br>* the whole document *<br>& US 2016/157356 A1 (KOHIKI MICHIYA [JP]) 2 June 2016 (2016-06-02)<br>* claims 21,25,26,36,38,39 *<br>* paragraphs [0288] - [0290], [0324], [0334] *<br>----- | 1-14 | |
| | | | TECHNICAL FIELDS SEARCHED (IPC) |
| | | | H05K |

The present search report has been drawn up for all claims

1

| Place of search | Date of completion of the search | Examiner |
|---|---|---|
| The Hague | 7 September 2017 | Dardel, Blaise |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 17 16 6671

This annex lists the patent family members relating to the patent documents cited in the above-mentioned European search report. The members are as contained in the European Patent Office EDP file on The European Patent Office is in no way liable for these particulars which are merely given for the purpose of information.

07-09-2017

| Patent document cited in search report | Publication date | Patent family member(s) | Publication date |
|---|---|---|---|
| US 2012285734 A1 | 15-11-2012 | CN 102803576 A | 28-11-2012 |
| | | EP 2527499 A1 | 28-11-2012 |
| | | JP 5242710 B2 | 24-07-2013 |
| | | JP 2011168887 A | 01-09-2011 |
| | | KR 20120123451 A | 08-11-2012 |
| | | TW 201139756 A | 16-11-2011 |
| | | US 2012285734 A1 | 15-11-2012 |
| | | WO 2011090175 A1 | 28-07-2011 |
| WO 2015012376 A1 | 29-01-2015 | CN 105408524 A | 16-03-2016 |
| | | EP 3026144 A1 | 01-06-2016 |
| | | KR 20160034915 A | 30-03-2016 |
| | | TW 201511628 A | 16-03-2015 |
| | | TW 201722228 A | 16-06-2017 |
| | | US 2016157356 A1 | 02-06-2016 |
| | | WO 2015012376 A1 | 29-01-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 4161304 B
- JP 4704025 B
- JP 2004244656 A
- WO 2008053878 A
- JP 2008111169 A
- JP 5024930 B
- WO 2006028207 A
- JP 4828427 B
- WO 2006134868 A
- JP 5046927 B
- WO 2007105635 A
- JP 5180815 B
- JP 2013019056 A
- WO 2008004399 A
- WO 2009084533 A
- JP 11005828 A
- JP 11140281 A
- JP 3184485 B
- WO 9702728 A
- JP 3676375 B
- JP 2000043188 A
- JP 3612594 B
- JP 2002179772 A
- JP 2002359444 A
- JP 2003304068 A
- JP 3992225 B
- JP 2003249739 A
- JP 4136509 B
- JP 2004082687 A
- JP 4025177 B
- JP 2004349654 A
- JP 4286060 B
- JP 2005262506 A
- JP 4570070 B
- JP 2005053218 A
- JP 3949676 B
- JP 4178415 B
- WO 2004005588 A
- JP 2006257153 A
- JP 2007326923 A
- JP 2009067029 A
- JP 2009173017 A
- WO 2008114858 A
- WO 2009008471 A
- JP 2011014727 A
- WO 2009001850 A
- WO 2009145179 A
- WO 2011068157 A


### Non-patent literature cited in the description


- A test method for copper-clad laminates for printed wiring boards dielectric constant and dissipation factor. JPCA-TM001-2007. Japan Electronics Packaging and Circuits Association